# EUROPEAN PATENT SPECIFICATION

(11) **EP 3 231 094 B1**
(45) Date of publication and mention of the grant of the patent: **29.11.2023**
(21) Application number: 15868223.7
(22) Date of filing: 07.12.2015
(51) Int. Cl.: H03M 13/25, H03M 13/03, H03M 13/11

(54) **METHOD AND APPARATUS FOR PARALLEL CONCATENATED LDPC CONVOLUTIONAL CODES ENABLING POWER-EFFICIENT DECODERS**
VERFAHREN UND VORRICHTUNG FÜR PARALLEL VERKETTETE LDPC-FALTUNGSCODES ZUR AKTIVIERUNG LEISTUNGSEFFIZIENTER DECODER
PROCÉDÉ ET APPAREIL POUR DES CODES CONVOLUTIONNELS LDPC CONCATÉNÉS EN PARALLÈLE ACTIVANT DES DÉCODEURS À FAIBLE CONSOMMATION D'ÉNERGIE

(30) Priority: 08.12.2014 US 201462089035 P; 14.04.2015 US 201562147410 P; 14.08.2015 US 201514827150
(43) Date of publication of application: 18.10.2017
(73) Proprietor: Samsung Electronics Co., Ltd., Gyeonggi-do 16677 (KR)
(72) Inventor: PISEK, Eran, Plano, Texas 75025 (US); ABU-SURRA, Shadi, Plano, Texas 75024 (US)
(74) Representative: HGF
(86) International application number: PCT/KR2015/013298
(87) International publication number: WO 2016/093568

(56) References cited:
- US-A1- 2010 299 573
- US-A1- 2011 078 533
- US-A1- 2012 170 678
- US-A1- 2012 240 006
- US-A1- 2013 086 455
- US-A1- 2014 223 254
- US-A1- 2014 223 254
- DANIEL COSTELLO ET AL: "Spatially coupled sparse codes on graphs: theory and practice", IEEE COMMUNICATIONS MAGAZINE., vol. 52, no. 7, 14 October 2013 (2013-10-14), pages 168-176, XP055233331, US ISSN: 0163-6804, DOI: 10.1109/MCOM.2014.6852099
- PUSANE A E ET AL: "Deriving Good LDPC Convolutional Codes from LDPC Block Codes", IEEE TRANSACTIONS ON INFORMATION THEORY, IEEE PRESS, USA, vol. 57, no. 2, 1 February 2011 (2011-02-01), pages 835-857, XP011348929, ISSN: 0018-9448, DOI: 10.1109/TIT.2010.2095211

## Description

### TECHNICAL FIELD

The present application relates generally to channel coding, and more specifically, to a method and apparatus for parallel concatenated low density parity check (LDPC) convolutional codes enabling power-efficient decoders

### Background Art

In information theory, a low-density parity-check (LDPC) code is an error correcting code for transmitting a message over a noisy transmission channel. LDPC codes are a class of linear block codes. While LDPC and other error correcting codes cannot guarantee perfect transmission, the probability of lost information can be made as small as desired. LDPC was the first code to allow data transmission rates close to the theoretical maximum known as the Shannon Limit. LDPC codes can perform with 0.0045 dB of the Shannon Limit. LDPC was impractical to implement when developed in 1963. Turbo codes, discovered in 1993, became the coding scheme of choice in the late 1990s. Turbo codes are used for applications such as deep-space satellite communications. LDPC requires complex processing, but is the most efficient scheme discovered as of 2007.

Capacity approaching LDPC codes have large block sizes (>>1000 bits) in order to realize efficiency. Block LDPC codes can be obtained in only a few block sizes such that the granularity of information being processed is coarse. The LDPC block codes are aligned to an orthogonal frequency-division multiplexing (OFDM) symbol. Accordingly, large block size codes reduce the flexibility of a system and significantly increase the latency.

Convolutional LDPC codes employ a complex design that is not quasi-cyclic. Convolutional LDPC codes employ complex decoding processes with a high number of iterations. Accordingly, convolutional LDPC codes are characterized by a low data rate and belief propagation only.

Trellis-based quasi-cyclic (TQC) LDPC convolutional codes provide a fine granularity, such as a lifting factor level (Z-level) of granularity. Example lifting factors include 42 bits or 27 bits. However, TQC-LDPC convolutional codes are non-capacity approaching, as such, the normalized signal to noise ratio (E_{b}/N₀) is approximately 2.5 decibels (dB) at a bit error rate (BER) of 10⁻⁵. The normalized signal to noise ratio is defined as the energy per bit (E_{b}) as compared to noise spectral density (N₀).

US2014/0223254 A1 discloses a low-density parity check (LDPC) encoding method for increasing constraint length, including determining a LDPC code block H-matrix including a systematic submatrix and a parity check submatrix of parity check bits. The method includes diagonalizing the parity check submatrix, identifying a set of rows of the H-matrix that form a complete set of the input systematic data, selecting an input bit granularity (γ) and encoding latency, and obtaining a quasi-cyclic LDPC (QC-LDPC) convolutional code H-Matrix.

US2013/086455 A1 discloses a method and apparatus for QC-LDPC convolutional coding and a low-power high throughput QC-LDPC convolutional encoder and decoder. The encoder generates, from a block code H-matrix comprising a data portion and a parity check portion, a continuous H-matrix by concatenating the data portion into successive, recurring, data blocks that are separated by a specified symbol interval, and performs LDPC encoding of each data portion using the parity check portion associated with the data portion using its associated parity check portion.

### Disclosure Of Invention

### Solution To Problem

This disclosure provides an apparatus and method for Parallel-concatenated Trellis-based QC-LDPC Convolutional Codes enabling power efficient decoders.

In a first embodiment, a method for encoding according to claim 1 is provided.

In a second embodiment, a method for decoding according to claim 6 is provided.

In a third embodiment, an apparatus according to claim 7 is provided.

Other technical features may be readily apparent to one skilled in the art from the following figures, descriptions, and claims.

Before undertaking the DETAILED DESCRIPTION below, it may be advantageous to set forth definitions of certain words and phrases used throughout this patent document. The term "couple" and its derivatives refer to any direct or indirect communication between two or more elements, whether or not those elements are in physical contact with one another. The terms "transmit," "receive," and "communicate," as well as derivatives thereof, encompass both direct and indirect communication. The terms "include" and "comprise," as well as derivatives thereof, mean inclusion without limitation. The term "or" is inclusive, meaning and/or. The phrase "associated with," as well as derivatives thereof, means to include, be included within, interconnect with, contain, be contained within, connect to or with, couple to or with, be communicable with, cooperate with, interleave, juxtapose, be proximate to, be bound to or with, have, have a property of, have a relationship to or with, or the like. The term "controller" means any device, system or part thereof that controls at least one operation. Such a controller may be implemented in hardware or a combination of hardware and software and/or firmware. The functionality associated with any particular controller may be centralized or distributed, whether locally or remotely. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

Definitions for other certain words and phrases are provided throughout this patent document. Those of ordinary skill in the art should understand that in many if not most instances, such definitions apply to prior as well as future uses of such defined words and phrases.

### Brief Description of Drawings

For a more complete understanding of the present disclosure and its advantages, reference is now made to the following description taken in conjunction with the accompanying drawings, in which like reference numerals represent like parts:
FIGURE 1 illustrates an example wireless network according to this disclosure;
FIGURES 2A and 2B illustrate example wireless transmit and receive paths according to this disclosure;
FIGURE 3 illustrates an example user equipment according to this disclosure;
FIGURE 4 illustrates an example enhanced NodeB according to this disclosure;
FIGURE 5 illustrates a Parallel Concatenated Trellis-based Quasi-Cyclic Low Density Parity Check Recursive Systematic Convolutional (QC-RSC) encoder according to this disclosure;
FIGURE 6 illustrates a Trellis-based Quasi-Cyclic Low Density Parity Check (TQC-LDPC) Maximum A posteriori Probability (MAP) decoder according to this disclosure;
FIGURE 7A illustrates a PC-LDPC encoding process according to this disclosure;
FIGURE 7B illustrates a PC-LDPC decoding process according to this disclosure;
FIGURE 8 illustrates the QC-RSC encoder of FIGURE 5 in more detail according to this disclosure;
FIGURE 9 illustrates a Recursive Systematic Convolutional (RSC) encoder according to this disclosure;
FIGURE 10 illustrates an example of a Spatially-coupled Low Density Parity Check (SC-LDPC) base code according to this disclosure;
FIGURE 11 illustrates another example of an SC-LDPC base code according to this disclosure;
FIGURE 12 illustrates a transformation of an SC-LDPC base code to an SC-LDPC code, to a serialized SC-LDPC code, to a concatenated SC-LDPC encoding structure according to this disclosure;
FIGURES 13A and 13B (together referred to as FIGURE 13) illustrates a process of generating a column of parity bits for a Parallel Concatenated Trellis-based Quasi-Cyclic Low Density Parity Check (PC-LDPC) convolutional code having an output rate of ½ from a concatenated SC-LDPC encoding structure having a separation of systematic bits from parity bits according to embodiments of this disclosure;
FIGURE 14 illustrates a process of generating a column of parity bits for a modified TQC-LDPC convolutional code having an output rate of ⅓ according to embodiments of this disclosure;
FIGURE 15 illustrates a process of puncturing by applying a puncturing pattern to the modified TQC-LDPC convolutional code having an output rate of ½ of FIGURE 14 according to embodiments of this disclosure;
FIGURE 16 illustrates a process of reducing periodicity while generating a column of parity bits for an example modified TQC-LDPC convolutional code having an output rate of ⅓ according to embodiments of this disclosure;
FIGURE 17 illustrates a process of process of reducing periodicity and puncturing by applying a puncturing pattern to the modified TQC-LDPC convolutional code having an output rate of ⅓ of FIGURE 16 according to embodiments of this disclosure;
FIGURE 18 illustrates a Dual-Step PC-LDPC convolutional code according to embodiments of this disclosure;
FIGURE 19 illustrates the TQC-LDPC MAP decoder of FIGURE 6 in more detail according to this disclosure;
FIGURE 20 illustrates a Normalized Complexity Comparison for a QC-MAP having an output rate of ½ and a bit error rate (BER) of 10⁻⁵ according to this disclosure;
FIGURE 21 illustrates a comparison table for QC-MAP hardware implementation including values corresponding to the graph in FIGURE 20 according to this disclosure;
FIGURE 22 illustrates an example Z Maximum A posteriori Probability (Z-MAP) decoder according to this disclosure;
FIGURE 23 illustrates an operation process of a transmitting node according to this disclosure; and
FIGURE 24 illustrates an operation process of a receiving node according to this disclosure according to this disclosure.

### Best Mode for Carrying out the Invention

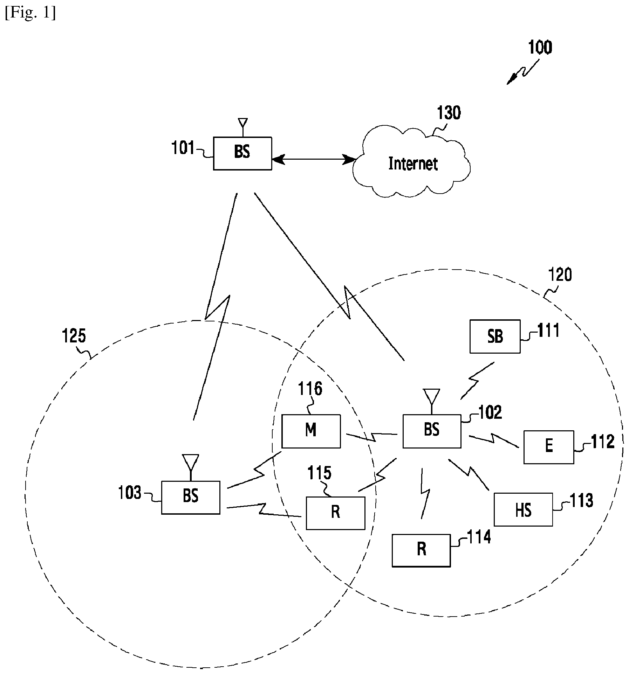

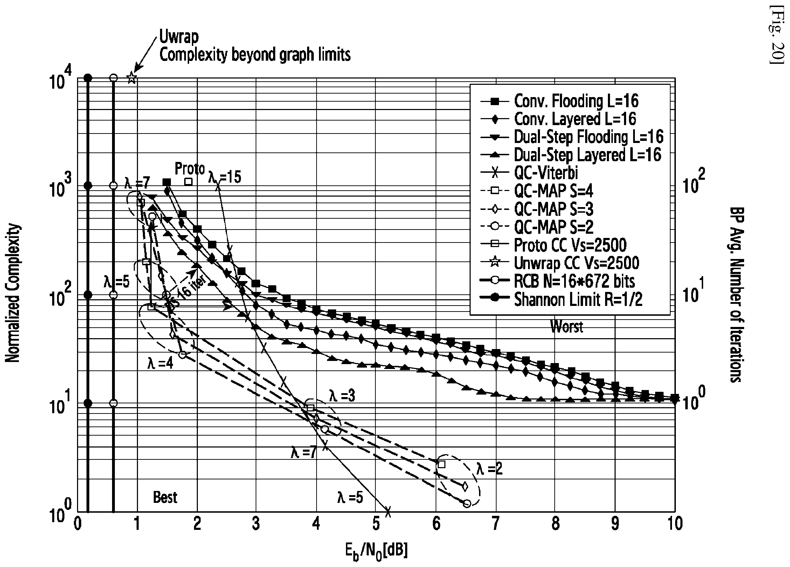

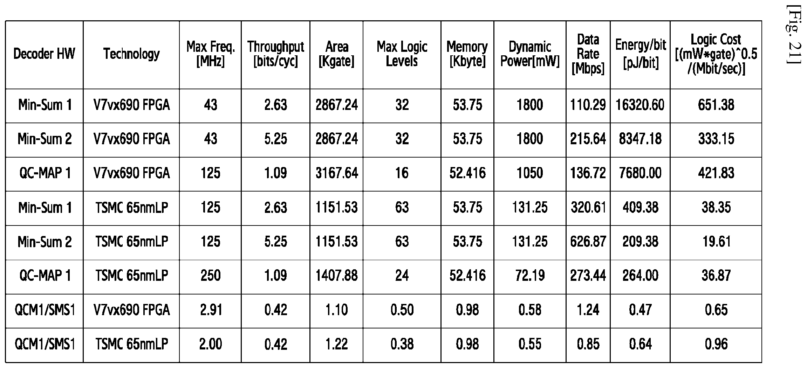

FIGURES 1 through 24, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device or system.

The following documents and standards descriptions are hereby incorporated into the present disclosure as if fully set forth herein: (i) L. Bahl, J. Cocke, F. Jelinek, J. Raviv, "Optimal Decoding of Linear Codes for minimizing symbol error rate", IEEE Transactions on Information Theory, vol. IT-20(2), pp. 284-287, March 1974 (hereinafter "REF1"); (ii) I. Chatzigeorgiou, M.R.D. Rodrigues, I.J. Wassell, R. Carrasco, "Pseudo-random Puncturing: A Technique to Lower the Error Floor of Turbo Codes," Information Theory, 2007. ISIT 2007. IEEE International Symposium on, vol., no., pp. 656-660, 24-29 Jun. 2007 (hereinafter "REF2"); (iii) C. Berrou, A. Glavieux and P. Thitimajshima, "Near-Shannon-limit error-correcting and decoding: Turbo codes (1)," in Proc. IEEE Int. Conf. Commun., vol. 2, pp. 23-26, Geneva, Switzerland, May 1993 (hereinafter "REF3"); (iv) R. G. Gallager, "Low-density parity-check codes," Ph.D. dissertation, Massachusetts Institute of Technology, Cambridge, MA, 1963 (hereinafter "REF4"); (v) D. J. C. MacKay, R. M. Neal, "Near Shannon limit performance of low density parity check codes," Electronics Letters, vol. 32, pp. 1645-1646, Aug. 1996 (hereinafter "REF5"); (vi) E. Boutillon, J. Castura, F. R. Kschischang, "Decoder-first code design," Proceedings of the 2nd International Symposium on Turbo Codes and Related Topics, Brest, France, Sep. 2000, pp. 459-462 (hereinafter "REF6"); (vii) T. Zhang, K. K. Parhi, "VLSI implementation-oriented (3,k)-regular low-density parity-check codes," 2001 IEEE Workshop on Signal Processing Systems, Antwerp, Belgium, Sep. 2001, pp. 25-36 (hereinafter "REF7"); (viii) R. V. Nee, "Breaking the Gigabit-per-second barrier with 802.11AC," Wireless Communications, IEEE, vol.18, no.2, pp. 4-8, Apr. 2011 (hereinafter "REF8"); (ix) IEEE 802.11ad standard specification, Part 11: Wireless LAN medium access control (MAC) and physical layer (PHY) Specifications, Amendment 3: "Enhancements for very high throughput in the 60 GHz Band," [On-line]. Available: http://standards.ieee.org/getieee802/ download/802.11ad-2012.pdf [Oct. 2014] (hereinafter "REF9"); (x) T. Baykas, S. Chin-Sean, L. Zhou, J. Wang, M. A. Rahman, H. Harada, S. Kato, "IEEE 802.15.3c: the first IEEE wireless standard for data rates over 1 Gb/s," Communications Magazine, IEEE, vol.49, no.7, pp.114-121, Jul. 2011 (hereinafter "REF10"); (xi) DVB-S2 Specification, ETSI EN 302 307 V1.2.1, (2009, Aug.), [On-line]. Available: http://www.etsi.org [Oct. 2014] (hereinafter "REF11"); (xii) A. J. Feltstrom, K. S. Zigangirov, "Time-varying periodic convolutional codes with low-density parity-check matrix," IEEE Transactions on IT, vol. IT-45, no. 6, pp. 2181-2191, Sep. 1999 (hereinafter "REF12"); (xiii) A. E. Pusane, A. J. Feltstrom, A. Sridharan, M. Lentimaier, K. S. Zigangirov, and D. J. Costello, Jr., "Implementation Aspects of LDPC convolutional Codes," IEEE Transactions on Communications, vol. 56, no. 7, pp. 1060-1069, Jul. 2008 (hereinafter "REF13"); (xiv) R. M. Tanner, D. Sridhara, A. Sridharan, T. E. Fuja, D. J. Costello, Jr., "LDPC Block and Convolutional Codes Based on Circulant Matrices," IEEE Transactions on Information Theory, vol. 50, no. 12, pp. 2966 - 2984, Dec. 2004 (hereinafter "REF14"); (xv) D. J. Costello, Jr., L. Dolecek, T. E. Fuja, J. Kliewer, D. G. M. Mitchell, R. Smarandache, (2013, Oct.), "Spatially Coupled Sparse Codes on Graphs - Theory and Practice," [On-line]. Available: http://arxiv.org/pdf/1310.3724.pdf [Oct. 2014] (hereinafter "REF15"); (xvi) 3GPP LTE Release 8 TSG RAN WG1, [On-Line]. Available: http://www.3gpp.org/RAN1-Radio-layer-1 [Oct. 2014] (hereinafter "REF16"); (xvii) J. Thorpe, "Low-density parity-check (LDPC) codes constructed from protographs," Jet Propulsion Lab, Pasadena, CA, INP Progress Report, pp. 42-154, Aug. 2003 (hereinafter "REF17"); (xviii) D. Divsalar, S. Dolinar, and C. Jones, "Protograph LDPC codes over burst erasure channels," Military Commun., IEEE, Oct. 2006, pp. 1-7 (hereinafter "REF18"); (xix) D. G. M. Mitchell, M. Lentmaier, D. J. Costello, Jr., "New families of LDPC block codes formed by terminating irregular protograph-based LDPC convolutional codes," in Proc. ISIT 2010, IEEE, Austin, TX, Jun. 2010, pp. 824-828 (hereinafter "REF19");.(xx) S. Abu-Surra, E. Pisek, T. Henige, "Gigabit rate achieving low-power LDPC codes: Design and architecture," WCNC 2011, IEEE, Cancun, Mexico, Mar. 2011. pp. 1994-1999 (hereinafter "REF20"); (xxi) S. Lin, D. J. Costello, Jr., Error Control Coding: Fundamentals and Applications. Englewood Cliffs, NJ: Prentice-Hall, 2nd ed., 2004 (hereinafter "REF21"); (xxii) E. Pisek, D. Rajan, J. Cleveland, "Gigabit rate low power LDPC decoder," Information Theory Workshop 2011, Paraty, Brazil, Oct. 2011. pp. 518-522 (hereinafter "REF22"); (xxiii) A. J. Viterbi, "Error bounds for convolutional codes and an asymptotically optimum decoding algorithm," IEEE Transactions on Information Theory, vol. 13, pp. 260-269, Apr. 1967 (hereinafter "REF23"); (xxiv) G. D. Forney, "The Viterbi algorithm," Proceedings of the IEEE, vol. 61, pp. 268-278, Mar. 1973 (hereinafter "REF24"); (xxv) A. E. Pusane, R. Smarandache, P. O. Vontobel, D. J. Costello, Jr., "Deriving Good LDPC Convolutional Codes from LDPC Block Codes," IEEE Transactions on Information Theory, Vol. 57, No. 2, pp. 835 - 857, Feb. 2011 (hereinafter "REF25"); (xxvi) J. He, H. Liu, Z. Wang, X. Huang, K. Zhang, "High-Speed Low-Power Viterbi Decoder Design for TCM Decoders," IEEE Transactions on Very Large Scale Integration (VLSI) Systems, vol. 20, no. 4, pp. 755-759, Apr. 2012 (hereinafter "REF26"); (xxvii) U.G. Nawathe, M. Hassan, K.C. Yen, A. Kumar, A. Ramachandran, D. Greenhill, "Implementation of an 8-Core, 64-Thread, Power-Efficient SPARC Server on a Chip," IEEE Journal of Solid-State Circuits, vol. 43, no. 1, pp .6-20, Jan. 2008 (hereinafter "REF27").

FIGURE 1 illustrates an example wireless network 100 according to this disclosure. The embodiment of the wireless network 100 shown in FIGURE 1 is for illustration only. Other embodiments of the wireless network 100 could be used without departing from the scope of this disclosure.

As shown in FIGURE 1, the wireless network 100 includes an eNodeB (eNB) 101, an eNB 102, and an eNB 103. The eNB 101 communicates with the eNB 102 and the eNB 103. The eNB 101 also communicates with at least one Internet Protocol (IP) network 130, such as the Internet, a proprietary IP network, or other data network.

Depending on the network type, other well-known terms may be used instead of "eNodeB" or "eNB," such as "base station" or "access point." For the sake of convenience, the terms "eNodeB" and "eNB" are used in this patent document to refer to network infrastructure components that provide wireless access to remote terminals. Also, depending on the network type, other well-known terms may be used instead of "user equipment" or "UE," such as "mobile station," "subscriber station," "remote terminal," "wireless terminal," or "user device." For the sake of convenience, the terms "user equipment" and "UE" are used in this patent document to refer to remote wireless equipment that wirelessly accesses an eNB, whether the UE is a mobile device (such as a mobile telephone or smartphone) or is normally considered a stationary device (such as a desktop computer or vending machine).

The eNB 102 provides wireless broadband access to the network 130 for a first plurality of user equipments (UEs) within a coverage area 120 of the eNB 102. The first plurality of UEs includes a UE 111, which may be located in a small business (SB); a UE 112, which may be located in an enterprise (E); a UE 113, which may be located in a WiFi hotspot (HS); a UE 114, which may be located in a first residence (R); a UE 115, which may be located in a second residence (R); and a UE 116, which may be a mobile device (M) like a cell phone, a wireless laptop, a wireless PDA, or the like. The eNB 103 provides wireless broadband access to the network 130 for a second plurality of UEs within a coverage area 125 of the eNB 103. The second plurality of UEs includes the UE 115 and the UE 116. In some embodiments, one or more of the eNBs 101 to 103 may communicate with each other and with the UEs 111 to 116 using 5G, LTE, LTE-A, WiMAX, or other advanced wireless communication techniques.

Dotted lines show the approximate extents of the coverage areas 120 and 125, which are shown as approximately circular for the purposes of illustration and explanation only. It should be clearly understood that the coverage areas associated with eNBs, such as the coverage areas 120 and 125, may have other shapes, including irregular shapes, depending upon the configuration of the eNBs and variations in the radio environment associated with natural and man-made obstructions.

As described in more detail below, one or more of eNBs 101 to 103 is configured to encode data using a Parallel Concatenated Trellis-based Quasi-Cyclic Low Density Parity Check Recursive Systematic Convolutional (QC-RSC) encoder to encode applying Parallel Concatenated Trellis-based Quasi-Cyclic Low Density Parity Check (PC-LDPC) convolutional code as described in embodiments of the present disclosure. In certain embodiments, one or more of eNBs 101 to 103 is configured to decode data using a Trellis-based Quasi-Cyclic Low Density Parity Check (TQC-LDPC) Maximum A posteriori Probability (MAP) decoder applying the PC-LDPC convolutional code as described in embodiments of the present disclosure. In certain embodiments, one or more of UEs 111 to 116 is configured to encode data using a QC-RSC encoder applying PC-LDPC convolutional code as described in embodiments of the present disclosure. In certain embodiments, one or more of UEs 111 to 116 is configured to decode data using a TQC-LDPC MAP decoder applying the PC-LDPC convolutional code as described in embodiments of the present disclosure.

Although FIGURE 1 illustrates one example of a wireless network 100, various changes may be made to FIGURE 1. For example, the wireless network 100 could include any number of eNBs and any number of UEs in any suitable arrangement. Also, the eNB 101 could communicate directly with any number of UEs and provide those UEs with wireless broadband access to the network 130. Similarly, each eNB 102 to 103 could communicate directly with the network 130 and provide UEs with direct wireless broadband access to the network 130. Further, the eNB 101, 102, and/or 103 could provide access to other or additional external networks, such as external telephone networks or other types of data networks.

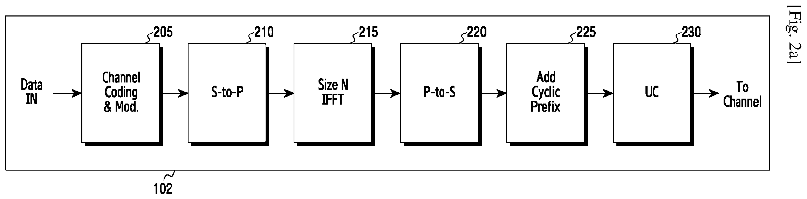

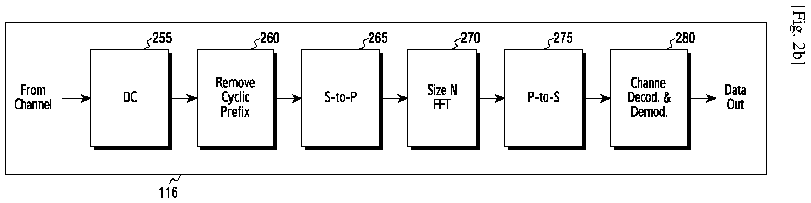

FIGURES 2A and 2B illustrate example wireless transmit and receive paths according to this disclosure. In the following description, a transmit path 200 may be described as being implemented in an eNB (such as eNB 102), while a receive path 250 may be described as being implemented in a UE (such as UE 116). However, it will be understood that the receive path 250 could be implemented in an eNB and that the transmit path 200 could be implemented in a UE. In certain embodiments, the transmit path 200 is configured to encode data using a QC-RSC encoder applying PC-LDPC convolutional code as described in embodiments of the present disclosure. In certain embodiments, the receive path 250 is configured to decode data a TQC-LDPC MAP decoder applying the PC-LDPC convolutional code as described in embodiments of the present disclosure.

The transmit path 200 includes a channel coding and modulation block 205, a serial-to-parallel (S-to-P) block 210, a size N Inverse Fast Fourier Transform (IFFT) block 215, a parallel-to-serial (P-to-S) block 220, an add cyclic prefix block 225, and an up-converter (UC) 230. The receive path 250 includes a down-converter (DC) 255, a remove cyclic prefix block 260, a serial-to-parallel (S-to-P) block 265, a size N Fast Fourier Transform (FFT) block 270, a parallel-to-serial (P-to-S) block 275, and a channel decoding and demodulation block 280.

In the transmit path 200, the channel coding and modulation block 205 receives a set of information bits, applies coding (such as a low-density parity check (LDPC) coding), and modulates the input bits (such as with Quadrature Phase Shift Keying (QPSK) or Quadrature Amplitude Modulation (QAM)) to generate a sequence of frequency-domain modulation symbols. The serial-to-parallel block 210 converts (such as de-multiplexes) the serial modulated symbols to parallel data in order to generate N parallel symbol streams, where N is the IFFT/FFT size used in the eNB 102 and the UE 116. The size N IFFT block 215 performs an IFFT operation on the N parallel symbol streams to generate time-domain output signals. The parallel-to-serial block 220 converts (such as multiplexes) the parallel time-domain output symbols from the size N IFFT block 215 in order to generate a serial time-domain signal. The add cyclic prefix block 225 inserts a cyclic prefix to the time-domain signal. The up-converter 230 modulates (such as up-converts) the output of the add cyclic prefix block 225 to an RF frequency for transmission via a wireless channel. The signal may also be filtered at baseband before conversion to the RF frequency.

A transmitted RF signal from the eNB 102 arrives at the UE 116 after passing through the wireless channel, and reverse operations to those at the eNB 102 are performed at the UE 116. The down-converter 255 down-converts the received signal to a baseband frequency, and the remove cyclic prefix block 260 removes the cyclic prefix to generate a serial time-domain baseband signal. The serial-to-parallel block 265 converts the time-domain baseband signal to parallel time domain signals. The size N FFT block 270 performs an FFT algorithm to generate N parallel frequency-domain signals. The parallel-to-serial block 275 converts the parallel frequency-domain signals to a sequence of modulated data symbols. The channel decoding and demodulation block 280 demodulates and decodes the modulated symbols to recover the original input data stream.

Each of the eNBs 101 to 103 may implement a transmit path 200 that is analogous to transmitting in the downlink to UEs 111 to 116 and may implement a receive path 250 that is analogous to receiving in the uplink from UEs 111 to 116. Similarly, each of UEs 111 to 116 may implement a transmit path 200 for transmitting in the uplink to eNBs 101 to 103 and may implement a receive path 250 for receiving in the downlink from eNBs 101 to 103.

Each of the components in FIGURES 2A and 2B can be implemented using only hardware or using a combination of hardware and software/firmware. As a particular example, at least some of the components in FIGURES 2A and 2B may be implemented in software, while other components may be implemented by configurable hardware or a mixture of software and configurable hardware. For instance, the FFT block 270 and the IFFT block 215 may be implemented as configurable software algorithms, where the value of size N may be modified according to the implementation.

Furthermore, although described as using FFT and IFFT, this is by way of illustration only and should not be construed to limit the scope of this disclosure. Other types of transforms, such as Discrete Fourier Transform (DFT) and Inverse Discrete Fourier Transform (IDFT) functions, could be used. It will be appreciated that the value of the variable N may be any integer number (such as 1, 2, 3, 4, or the like) for DFT and IDFT functions, while the value of the variable N may be any integer number that is a power of two (such as 1, 2, 4, 8, 16, or the like) for FFT and IFFT functions.

Although FIGURES 2A and 2B illustrate examples of wireless transmit and receive paths, various changes may be made to FIGURES 2A and 2B. For example, various components in FIGURES 2A and 2B could be combined, further subdivided, or omitted and additional components could be added according to particular needs. Also, FIGURES 2A and 2B are meant to illustrate examples of the types of transmit and receive paths that could be used in a wireless network. Any other suitable architectures could be used to support wireless communications in a wireless network.

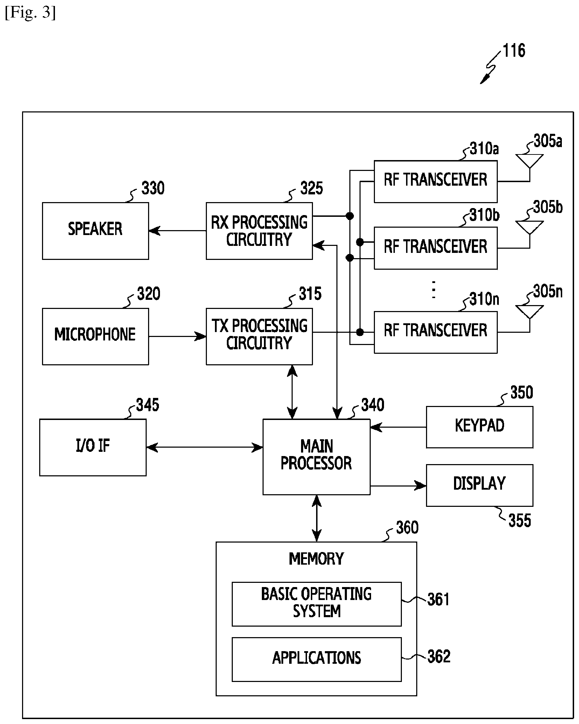

FIGURE 3 illustrates an example UE 116 according to this disclosure. The embodiment of the UE 116 illustrated in FIGURE 3 is for illustration only, and the UEs 111 to 115 of FIGURE 1A could have the same or similar configuration. However, UEs come in a wide variety of configurations, and FIGURE 3 does not limit the scope of this disclosure to any particular implementation of a UE.

The UE 116 includes multiple antennas 305a-305n, radio frequency (RF) transceivers 310a-310n, transmit (TX) processing circuitry 315, a microphone 320, and receive (RX) processing circuitry 325. The TX processing circuitry 315 and RX processing circuitry 325 are respectively coupled to each of the RF transceivers 310a-310n, for example, coupled to RF transceiver 310a, RF transceiver 210b through to a Nth RF transceiver 310n, which are coupled respectively to antenna 305a, antenna 305b and an Nth antenna 305n. In certain embodiments, the UE 116 includes a single antenna 305a and a single RF transceiver 310a. The UE 116 also includes a speaker 330, a main processor 340, an input/output (I/O) interface (IF) 345, a keypad 350, a display 355, and a memory 360. The memory 360 includes a basic operating system (OS) program 361 and one or more applications 362.

The RF transceivers 310a-310n receive, from respective antennas 305a-305n, an incoming RF signal transmitted by an eNB or AP of the network 100. In certain embodiments, each of the RF transceivers 310a-310n and respective antennas 305a-305n is configured for a particular frequency band or technological type. For example, a first RF transceiver 310a and antenna 305a can be configured to communicate via a near-field communication, such as BLUETOOTH^{®}, while a second RF transceiver 310b and antenna 305b can be configured to communicate via a IEEE 802.11 communication, such as Wi-Fi, and another RF transceiver 310n and antenna 305n can be configured to communicate via cellular communication, such as 3G, 4G, 5G, LTE, LTE-A, or WiMAX. In certain embodiments, one or more of the RF transceivers 310a-310n and respective antennas 305a-305n is configured for a particular frequency band or same technological type. The RF transceivers 310a-310n down-converts the incoming RF signal to generate an intermediate frequency (IF) or baseband signal. The IF or baseband signal is sent to the RX processing circuitry 325, which generates a processed baseband signal by filtering, decoding, and/or digitizing the baseband or IF signal. The RX processing circuitry 325 transmits the processed baseband signal to the speaker 330 (such as for voice data) or to the main processor 340 for further processing (such as for web browsing data).

The TX processing circuitry 315 receives analog or digital voice data from the microphone 320 or other outgoing baseband data (such as web data, e-mail, or interactive video game data) from the main processor 340. The TX processing circuitry 315 encodes, multiplexes, and/or digitizes the outgoing baseband data to generate a processed baseband or IF signal. The RF transceivers 310a-310n receive the outgoing processed baseband or IF signal from the TX processing circuitry 315 and up-converts the baseband or IF signal to an RF signal that is transmitted via one or more of the antennas 305a-305n.

The main processor 340 can include one or more processors or other processing devices and execute the basic OS program 361 stored in the memory 360 in order to control the overall operation of the UE 116. For example, the main processor 340 could control the reception of forward channel signals and the transmission of reverse channel signals by the RF transceivers 310a-310n, the RX processing circuitry 325, and the TX processing circuitry 315 in accordance with well-known principles. In some embodiments, the main processor 340 includes at least one microprocessor or microcontroller. The main processor 340 includes processing circuitry configured to encode or decode data information, such as including a QC-RSC encoder processing circuitry configured to apply PC-LDPC convolutional code, a TQC-LDPC MAP decoder processing circuitry configured to apply the PC-LDPC convolutional code; a QC-RSC encoder; a TQC-LDPC MAP decoder; or a combination thereof.

The main processor 340 is also capable of executing other processes and programs resident in the memory 360, such as operations for applying PC-LDPC convolutional code for encoding in a QC-RSC encoder or decoding in TQC-LDPC MAP decoder as described in embodiments of the present disclosure. The main processor 340 can move data into or out of the memory 360 as required by an executing process. In some embodiments, the main processor 340 is configured to execute the applications 362 based on the OS program 361 or in response to signals received from eNBs or an operator. The main processor 340 is also coupled to the I/O interface 345, which provides the UE 116 with the ability to connect to other devices such as laptop computers and handheld computers. The I/O interface 345 is the communication path between these accessories and the main controller 340.

The main processor 340 is also coupled to the keypad 350 and the display unit 355. The user of the UE 116 can use the keypad 350 to enter data into the UE 116. The display 355 can be a liquid crystal display or other display capable of rendering text or at least limited graphics, such as from web sites, or a combination thereof.

The memory 360 is coupled to the main processor 340. Part of the memory 360 could include a random access memory (RAM), and another part of the memory 360 could include a Flash memory or other read-only memory (ROM).

Although FIGURE 3 illustrates one example of UE 116, various changes may be made to FIGURE 3. For example, various components in FIGURE 3 could be combined, further subdivided, or omitted and additional components could be added according to particular needs. As a particular example, the main processor 340 could be divided into multiple processors, such as one or more central processing units (CPUs) and one or more graphics processing units (GPUs). Also, while FIGURE 3 illustrates the UE 116 configured as a mobile telephone or smartphone, UEs could be configured to operate as other types of mobile or stationary devices.

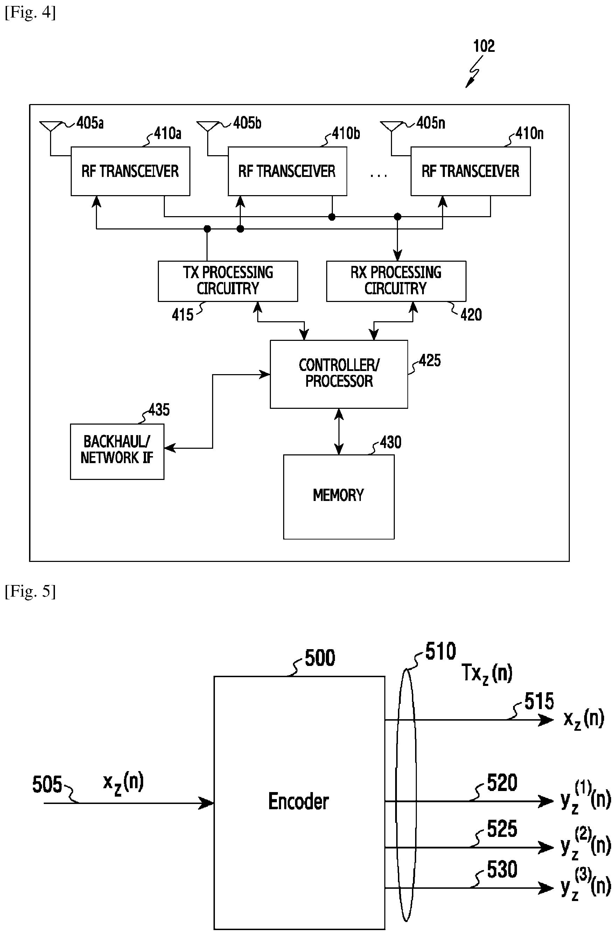

FIGURE 4 illustrates an example eNB 102 according to this disclosure. The embodiment of the eNB 102 shown in FIGURE 4 is for illustration only, and other eNBs of FIGURE 1 could have the same or similar configuration. However, eNBs come in a wide variety of configurations, and FIGURE 4 does not limit the scope of this disclosure to any particular implementation of an eNB.

The eNB 102 includes multiple antennas 405a-405n, multiple RF transceivers 410a-410n, transmit (TX) processing circuitry 415, and receive (RX) processing circuitry 420. The eNB 102 also includes a controller/processor 425, a memory 430, and a backhaul or network interface 435.

The RF transceivers 410a-410n receive, from the antennas 405a-405n, incoming RF signals, such as signals transmitted by UEs or other eNBs. The RF transceivers 410a-410n down-convert the incoming RF signals to generate IF or baseband signals. The IF or baseband signals are sent to the RX processing circuitry 420, which generates processed baseband signals by filtering, decoding, and/or digitizing the baseband or IF signals. The RX processing circuitry 420 transmits the processed baseband signals to the controller/ processor 425 for further processing.

The TX processing circuitry 415 receives analog or digital data (such as voice data, web data, e-mail, or interactive video game data) from the controller/processor 425. The TX processing circuitry 415 encodes, multiplexes, and/or digitizes the outgoing baseband data to generate processed baseband or IF signals. The RF transceivers 410a-410n receive the outgoing processed baseband or IF signals from the TX processing circuitry 415 and up-converts the baseband or IF signals to RF signals that are transmitted via the antennas 405a-405n.

The controller/processor 425 can include one or more processors or other processing devices that control the overall operation of the eNB 102. For example, the controller/ processor 425 could control the reception of forward channel signals and the transmission of reverse channel signals by the RF transceivers 410a-410n, the RX processing circuitry 420, and the TX processing circuitry 415 in accordance with well-known principles. The controller/processor 425 could support additional functions as well, such as applying PC-LDPC convolutional code for encoding in a QC-RSC encoder or decoding in TQC-LDPC MAP decoder as described in embodiments of the present disclosure. Any of a wide variety of other functions could be supported in the eNB 102 by the controller/processor 425. In some embodiments, the controller/ processor 425 includes at least one microprocessor or microcontroller. The controller/ processor 425 includes processing circuitry configured to encode or decode data information, such as including a QC-RSC encoder that applies PC-LDPC convolutional code for encoding data, a TQC-LDPC MAP decoder the applies the PC-LDPC convolutional code for decoding data; a QC-RSC encoder; a TQC-LDPC MAP decoder; or a combination thereof.

The controller/processor 425 is also capable of executing programs and other processes resident in the memory 430, such as a basic OS. The controller/processor 425 can move data into or out of the memory 430 as required by an executing process.

The controller/processor 425 is also coupled to the backhaul or network interface 435. The backhaul or network interface 435 allows the eNB 102 to communicate with other devices or systems over a backhaul connection or over a network. The interface 435 could support communications over any suitable wired or wireless connection(s). For example, when the eNB 102 is implemented as part of a cellular communication system (such as one supporting 5G, LTE, or LTE-A), the interface 435 could allow the eNB 102 to communicate with other eNBs over a wired or wireless backhaul connection. When the eNB 102 is implemented as an access point, the interface 435 could allow the eNB 102 to communicate over a wired or wireless local area network or over a wired or wireless connection to a larger network (such as the Internet). The interface 435 includes any suitable structure supporting communications over a wired or wireless connection, such as an Ethernet or RF transceiver.

The memory 430 is coupled to the controller/processor 425. Part of the memory 330 could include a RAM, and another part of the memory 430 could include a Flash memory or other ROM.

As described in more detail below, the transmit and receive paths of the eNB 102 (implemented using the RF transceivers 410a-410n, TX processing circuitry 415, and/ or RX processing circuitry 420) support communication with aggregation of FDD cells and TDD cells.

Although FIGURE 4 illustrates one example of an eNB 102, various changes may be made to FIGURE 4. For example, the eNB 102 could include any number of each component shown in FIGURE 4. As a particular example, an access point could include a number of interfaces 435, and the controller/processor 425 could support routing functions to route data between different network addresses. As another particular example, while shown as including a single instance of TX processing circuitry 415 and a single instance of RX processing circuitry 420, the eNB 102 could include multiple instances of each (such as one per RF transceiver).

LDPC codes have received a great deal of attention in recent years. This is due to their ability to achieve performance close to the Shannon limit, the ability to design codes that facilitate high parallelization in hardware, and their support of high data rates. The most commonly deployed form of the LDPC codes are the block LDPC codes. However, in highly dynamic wireless communication systems, where the channel conditions and the data allocation per user are continuously changing, block LDPC codes offer rather limited flexibility.

PC-LDPC convolutional codes are new capacity-approaching codes, which are a special case of Trellis-based Quasi-Cyclic LDPC (TQC-LDPC) convolutional codes. A PC-LDPC convolutional code can be derived from any QC-LDPC block code by introducing trellis-based convolutional dependency to the code. PC-LDPC codes combine the advantages of both convolutional LDPC codes and LDPC block codes. PC-LDPC codes form a special class of LDPC codes that reduces LDPC block granularity from a block size (γ) granularity to a fine input granularity on the order of a lifting-factor (Z) size granularity of the underlying block code. The PC-LDPC convolutional code maintains a low bit error ratio (BER) and enables low complexity (X) encoder and decoder architecture. Hence, PC-LDPC codes have parity check matrices with convolutional structure. This structure allows for scalable code-length with fine granularity compared to the other block LDPC codes. In addition, PC-LDPC codes inherit the high parallel processing capabilities of LDPC codes, and are therefore capable of supporting multiple GBs throughput.

The capacity-approaching PC-LDPC convolutional codes are encoded through Parallel Concatenated Trellis-based Quasi-Cyclic LDPC Recursive Systematic Convolutional encoder namely, a QC-RSC encoder.

The PC-LDPC convolutional codes with the QC-MAP decoder have two times lower complexity for a given Bit-Error-Rate (BER), Signal-to-Noise Ratio (SNR), and data rate, than conventional QC-LDPC block codes and conventional LDPC convolutional codes. The PC-LDPC convolutional code with the QC-MAP decoder outperforms the conventional QC-LDPC block codes by more than 0.5 dB for a given Bit-Error-Rate (BER), complexity, and data rate and approaches Shannon capacity limit with a gap smaller than 1.25 dB. This low decoding complexity and the fine granularity makes it feasible for the proposed capacity-approaching PC-LDPC convolutional code and the associated trellis-based QC-MAP decoder to be efficiently implemented in ultra-high data rate next generation mobile systems.

FIGURE 5 illustrates a Parallel Concatenated Trellis-based Quasi-Cyclic Low Density Parity Check Recursive Systematic Convolutional (QC-RSC) encoder 500 according to this disclosure. The embodiment of the QC-RSC encoder 500 shown in FIGURE 5 is for illustration only. Other embodiments could be used without departing from the scope of the present disclosure.

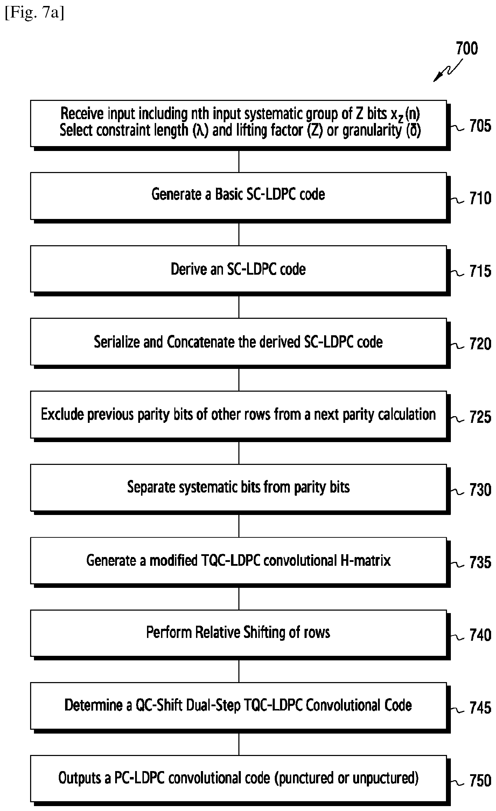

The QC-RSC encoder 500 can be included in the UE 116 or in the eNB 102. The QC-RSC encoder 500 receives information to be encoded as input 505. More particularly, the input 505 includes systematic data in the form of a Z-group of systematic bits x_{Z}(n). The QC-RSC encoder 500 encodes the input 505 by implementing a PC-LDPC encoding process 700 (described in further detail with reference to FIGURE 7A). The QC-RSC encoder 500 outputs an encoded version of the received information as output 510. The encoded information output 510 includes a code block in the form of an H-matrix, wherein the H-matrix includes a systematic submatrix (H_{sys}) of the input systematic data and a parity check submatrix (Hₚₐᵣ) of parity check bits. The systematic submatrix (H_{sys}) includes the information inputted to the encoder 500. The parity check submatrix (Hₚₐᵣ) includes one or more parity bits per systematic bit. In the example shown, the output 510 includes the systematic data x_{Z}(n) 515, a first Z-group of parity bits ${y}_{Z}^{\left(1\right)} \left(n\right) 520$, a second Z-group of parity bits ${y}_{Z}^{\left(2\right)} \left(n\right) 525$, and a third Z-group of parity bits ${y}_{Z}^{\left(3\right)} \left(n\right) 530$.

The QC-RSC encoder 500 is configured based on an underlying LDPC block code parity check matrix H having a lifting factor Z and JZ rows (referred to as J sets of Z-rows) and BZ systematic columns (referred to as B sets of systematic Z-columns). That is, the underlying LDPC block code parity check matrix H includes a systematic part and a parity part, namely, a systematic submatrix (H_{sys}) and a parity check submatrix (Hₚₐᵣ). The underlying LDPC block code parity check matrix H is defined according to Equation 1. The parity check submatrix (Hₚₐᵣ) includes the J sets of Z-rows and a number (for example, J) of sets of parity Z-columns. The systematic submatrix (H_{sys}) includes the J sets of Z-rows and the B sets of systematic Z-columns. The systematic submatrix (H_{sys}) is defined according to Equation 2. The systematic submatrix (H_{sys}) includes JB Z-groups, each referred to as ***H_{zsys}***(*j, l*). As shown in Equation 3, the systematic part of the j-th Z-row and l-th Z-column of the underlying LDPC block code H is defined as ***H_{zsys}***(*j, l*) for j=0,...,J-1,and 1=0,...,B-1. The input 505 is an input sequence that includes one or more cyclically shifted Z-group input bits, wherein x_{z}(n) is defined as the n-th group of Z (namely Z-group) bits of the input sequence, and wherein n is an index of the input sequence from n=0, ..., JB-1. More particularly, the n-th cyclically shifted Z-group input bits corresponding to the j-th Z-row of ***H_{zsys}*** is referred to as ${x}_{z}^{\left(j\right)} \left(n\right)$, as defined in Equations 4, where (n mod B) is n modulo B.$H = {H}_{sys} | {H}_{par}$${H}_{sys} = \left[\begin{matrix}{H}_{{Z}_{sys}} \left(0,0\right) & {H}_{{Z}_{sys}} \left(j, l\right) & ⋯ & {H}_{{Z}_{sys}} \left(0,B-1\right) \\ ⋮ & ⋮ & ⋱ & ⋮ \\ {H}_{{Z}_{sys}} \left(J-1,0\right) & {H}_{{Z}_{sys}} \left(j, l\right) & ⋯ & {H}_{{Z}_{sys}} \left(J-1,B-1\right)\end{matrix}\right]$${H}_{{Z}_{sys}} \left(j, l\right) = \left[\begin{matrix}{x}_{Z}^{\left(0\right)} \left(0\right) & {x}_{Z}^{\left(j\right)} \left(n\right) & ⋯ & {x}_{z}^{\left(0\right)} \left(Z-1\right) \\ ⋮ & ⋮ & ⋱ & ⋮ \\ {x}_{Z}^{\left(Z-1\right)} & {x}_{Z}^{\left(j\right)} \left(n\right) & ⋯ & {x}_{Z}^{\left(Z-1\right)} \left(Z-1\right)\end{matrix}\right]$${x}_{z}^{\left(j\right)} \left(n\right) ≡ {x}_{z} \left(n\right) {H}_{{z}_{sys}}^{T} \left(n mod B,j\right)$

The QC-RSC encoder 500 illustrated in FIGUIRE 5 may be included a transmitting node. A codeword encoded by the QC-RSC encoder 500 may be is transmitted to a receiving node though a radio channel. In order to transmit the codeword, the transmitting node may further include at least one module or unit configured to modulate the codeword and at least one module or unit configured to generate radio frequency (RF) signals (e.g. a mixer, a power amplifier, an oscillator and so on).

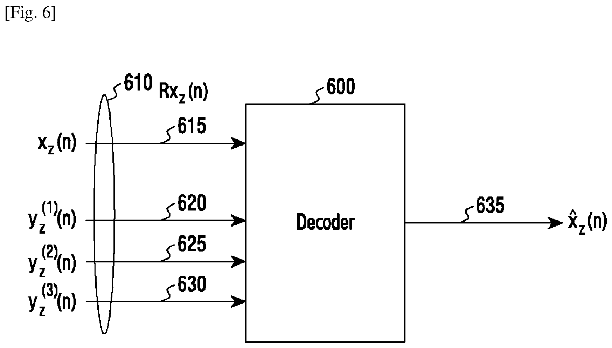

FIGURE 6 illustrates a Trellis-based Quasi-Cyclic Low Density Parity Check (TQC-LDPC) Maximum A posteriori Probability (MAP) decoder 600 according to this disclosure. The embodiment of the TQC-LDPC MAP decoder 600 shown in FIGURE 6 is for illustration only. Other embodiments could be used without departing from the scope of the present disclosure.

The TQC-LDPC MAP decoder 600 can be included in the UE 116 or in the eNB 102. The TQC-LDPC MAP decoder 600 receives information Rx_{Z}(n) to be decoded and a set of parity log-likelihood ratios (LLR) as input 610. In the input 610, the Rx_{z}(n) is the n-th Z-group received systematic log-likelihood ratio (LLR) set in a non-interleaved mode. Also, the set of parity LLRs are referred to as ${Ry}_{z}^{\left(j\right)} \left(n\right)$ ,j∈{0,...,J-1=2} where each ${Ry}_{z}^{\left(j\right)} \left(n\right)$ is already interleaved by the corresponding quasi-cyclic shifts related to ***H_{Zsys}*** Z-row j. More particularly, the input 610 includes encoded information, namely, a code block in the form of an H-matrix, wherein the H-matrix includes a systematic submatrix (H_{sys}) of the input systematic data and a parity check submatrix (Hₚₐᵣ) of parity check bits. The systematic submatrix (H_{sys}) includes the information inputted to the encoder 500. The parity check submatrix (Hₚₐᵣ) includes one or more parity bits per systematic bit. In the example shown, the input 610 includes the systematic data 615 in the form of a Z-group of systematic bits x_{Z}(n), a first Z-group of parity bits ${y}_{Z}^{\left(1\right)} \left(n\right) 620$, a second Z-group of parity bits ${y}_{Z}^{\left(2\right)} \left(n\right) 625$, and a third Z-group of parity bits ${y}_{Z}^{\left(3\right)} \left(n\right) 630$. The TQC-LDPC MAP decoder 600 decodes the input 610 by implementing a PC-LDPC decoding process (described in further detail below). The TQC-LDPC MAP decoder 600 outputs an decoded version of the received information as output 635.

For simplicity, this disclosure will be described in the context of an example scenario in which the eNB 102 includes the QC-RSC encoder and transmits the encoded information output Tx_{Z}(n) 510 to the UE 116, and correspondingly, the UE 116 includes the decoder 600 receives encoded information Rx_{Z}(n) 610. In the case of a perfect channel between the transmitter of the eNB 102 and receiver of the UE 116, the output 510 from the encoder 500 is identical to the input 610 to the decoder 600. In the case of perfect operation of the encoder 500 and decoder 600, the systematic information x_{Z} (n) 505 is identical to the information 515, 615, and 635; and the first parity information ${y}_{Z}^{\left(1\right)} \left(n\right) 520$ is the same as the information 620; the second parity information ${y}_{z}^{\left(2\right)} \left(n\right) 525$ is the same as the information 625, and the third parity information ${y}_{z}^{\left(3\right)} \left(n\right) 530$ is the same as the information 630.

The TQC-LDPC MAP decoder 600 illustrated in FIGUIRE 6 may be included a receiving node. The encoded information Rx_{Z}(n) 610 may be is received from a transmitting node to the receiving node though a radio channel. In order to receive the encoded information Rx_{Z}(n) 610, the receiving node may further include at least one module or unit configured to process radio frequency (RF) signals (e.g. a mixer, a low noise amplifier, an oscillator and so on) and at least one module or unit configured to demodulate the codeword.

FIGURE 7A illustrates a PC-LDPC encoding process 700 according to this disclosure. While the flow chart depicts a series of sequential steps, unless explicitly stated, no inference should be drawn from that sequence regarding specific order of performance, performance of steps or portions thereof serially rather than concurrently or in an overlapping manner, or performance of the steps depicted exclusively without the occurrence of intervening or intermediate steps. The process depicted in the example depicted is implemented by encoder circuitry or processing circuitry in a transmitter such as, for example, in a base station.

In block 705, the QC-RSC encoder 500 receives the input 505 of information to be encoded. Also in block 705, the QC-RSC encoder 500 selects a lifting factor (Z) and a constraint length (λ) the input 505. The lifting factor (Z) represents the input granularity (δ), as the QC-RSC encoder 500 is configured to encode a matrix of systematic data having a size of ZxZ permutation matrix.

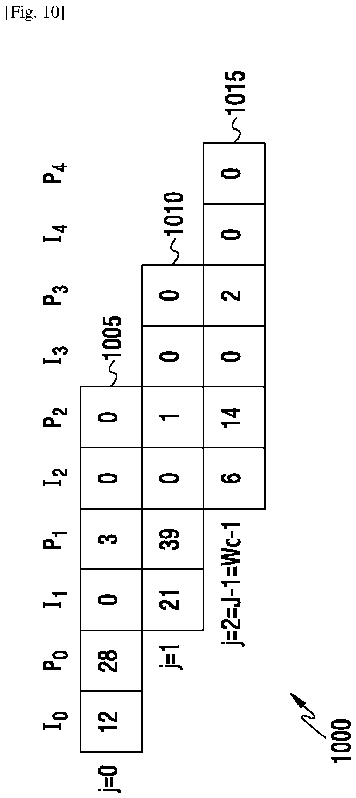

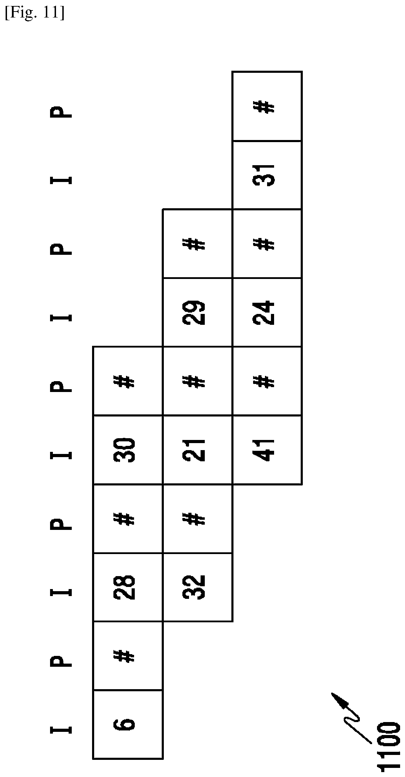

In block 710, the QC-RSC encoder 500 generates a Spatially-Coupled (SC) Low Density Parity Check (LDPC) base code based on the input 505. The SC-LDPC base code is discussed in further detail with reference to FIGURES 10 and 11. The SC-LDPC base code is characterized by a row weight (Wr), a column weight (Wc), and a first level lifting factor (Z).

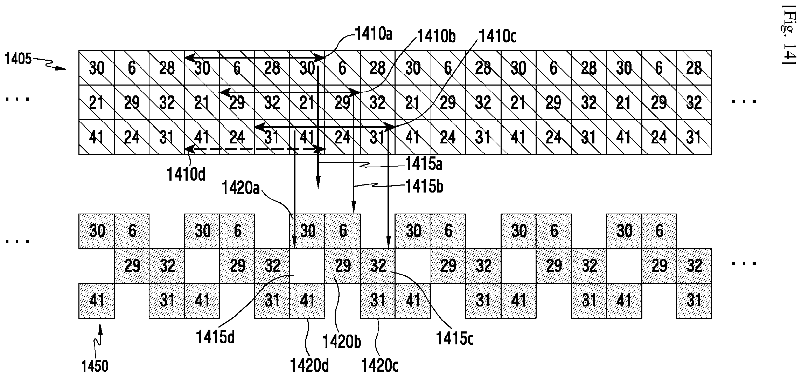

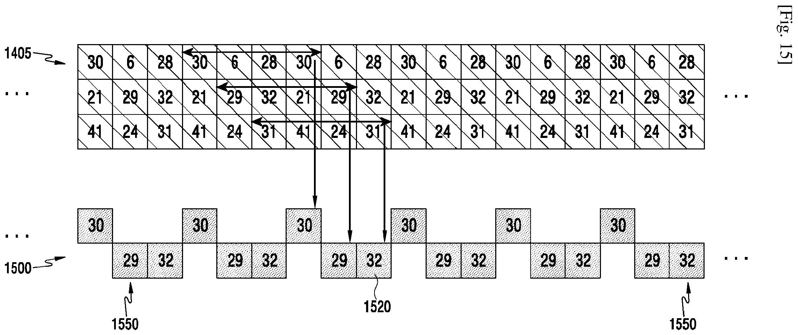

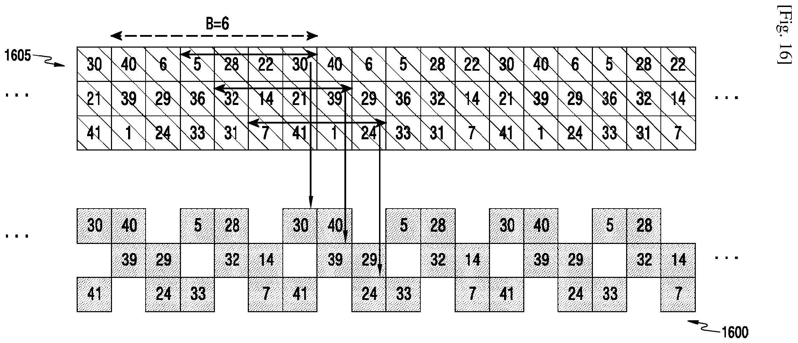

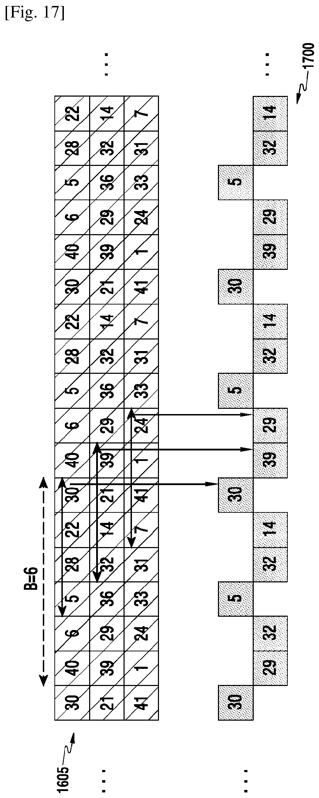

As part of deriving the SC-LDPC base code, the QC-RSC encoder 500 can reduce the bit error rate (BER) and periodicity of the convolutional code by increasing the size (B) of the underlying LDPC systematic H-matrix (*H_{Zsys}*) in Z-group bits. The size (B) of the *H_{Zsys}* matrix is equivalent to the row weight (Wr) of the SC-LDPC base code. Such a reduction is shown by comparing the size B=3 modified TQC-LDPC convolutional H-Matrix of FIGURES 14 and 15 to the size B=6 modified TQC-LDPC convolutional H-Matrix of FIGURES 16 and 17.

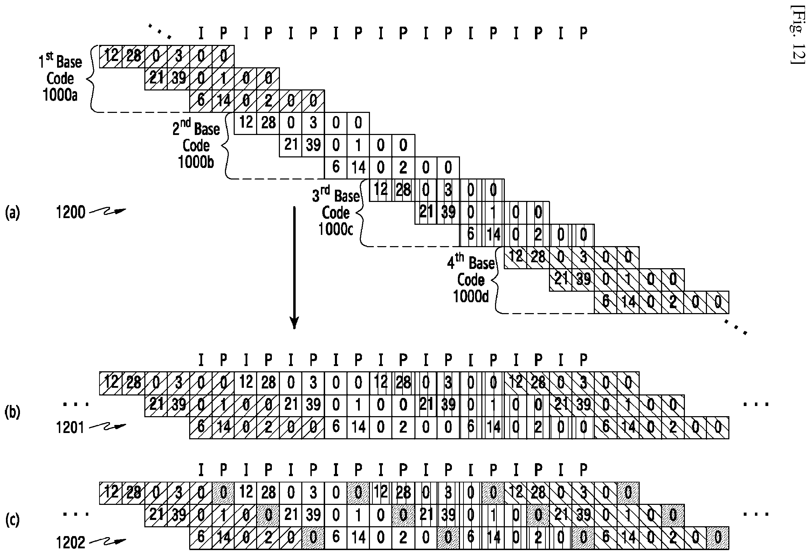

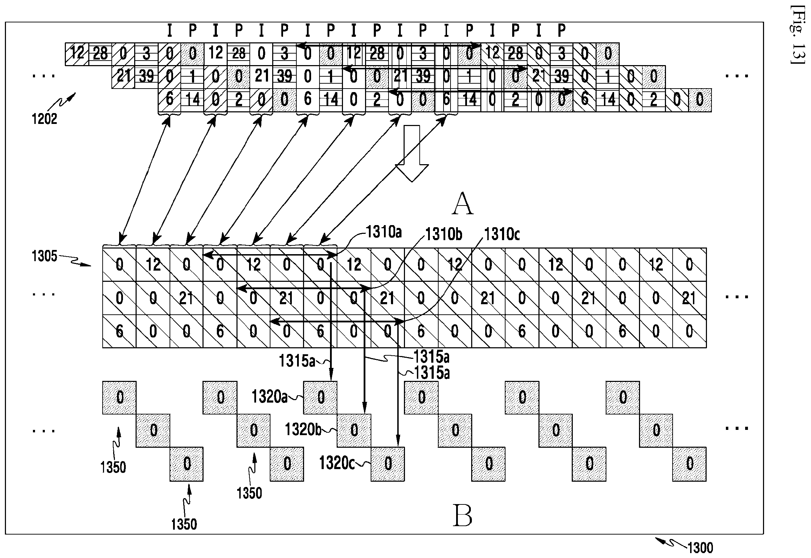

In blocks 715-730, the QC-RSC encoder 500 transforms the SC-LDPC base code into a Trellis-based Quasi-Cyclic LDPC (TQC-LDPC) convolutional code. In order to transform the SC-LDPC base code into a PC-LDPC convolutional code, the QC-RSC encoder 500 derives an SC-LDPC code based on the SC-LDPC base code (shown in part (a) of FIGURE 12) (block 715), serializes and concatenates the derived SC-LDPC code into a concatenated SC-LDPC encoding structure (shown respectively in parts (b) and (c) of FIGURE 12) (block 720), excludes previous parity bits of other rows from a next parity calculation (shown in FIGURE 13A) (block 725), and separates systematic bits from parity bits, yielding a derived TQC-LDPC convolutional code (shown in FIGURE 13B) (block 730).

In addition to transforming the SC-LDPC base code into a PC-LDPC convolutional code, the QC-RSC encoder 500 is configured to select: (i) whether to generate a modified TQC-LDPC convolutional H-matrix; (ii) whether to perform relative shifting; (iii) whether to puncture one or more rows, and (iv) whether to implement a Dual-Step PC-LDPC Convolutional code. When the QC-RSC encoder 500 selects to generate a modified TQC-LDPC convolutional H-matrix, the process 700 proceeds to block 735, otherwise, the process skips block 735 and proceeds to block 740. When the QC-RSC encoder 500 selects to perform relative shifting, the process 700 proceeds to block 740, otherwise, the process skips block 740 and proceeds to block 745. When the QC-RSC encoder 500 selects to implement a Dual-Step PC-LDPC Convolutional code, the process 700 proceeds to block 745, otherwise, the process skips block 745 and proceeds to block 750.

In block 735, the QC-RSC encoder 500 generates a modified TQC-LDPC convolutional H-matrix (shown in FIGURES 14 and 15). More particularly, the QC-RSC encoder 500 changes the quasi-cyclic values in order to generate the modified TQC-LDPC convolutional H-matrix.

In block 740, the QC-RSC encoder 500 performs relative shifting by using one row as a reference row while shifting the remainder of the rows. More particularly, the QC-RSC encoder 500 selects a reference row, such as first row or other row. All shift entries of the reference row are "0" to denote the unity matrix. The QC-RSC encoder 500 shifts each other row relative to the selected reference row.

In block 745, the QC-RSC encoder 500 determines a QC-Shift Dual-Step TQC-LDPC Convolutional Code.

In block 750, the QC-RSC encoder 500 outputs a PC-LDPC convolutional code. More particularly, the QC-RSC encoder 500 generates each row of parity (J) in Z-group bits in parallel and selects which row parity bits to output. For example, the QC-RSC encoder 500 can select to output one parity per column (shown in FIGURE 13B), two parity per column (shown in FIGURES 14 and 16), or any number of parity up to the column rate (Wc) of the SC-LDPC base code.

As part of outputting parity, in response to a selection to perform puncturing, the QC-RSC encoder 500 punctures one or more rows of parity. More particularly, the QC-RSC encoder 500 increases the output rate (R) by performing a puncturing operation. In certain embodiments, the QC-RSC encoder 500 punctures according to a puncturing pattern.

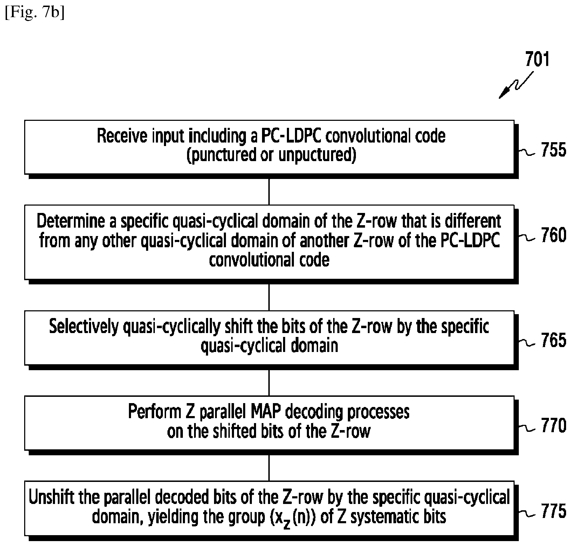

FIGURE 7B illustrates a PC-LDPC decoding process 701 according to this disclosure. While the flow chart depicts a series of sequential steps, unless explicitly stated, no inference should be drawn from that sequence regarding specific order of performance, performance of steps or portions thereof serially rather than concurrently or in an overlapping manner, or performance of the steps depicted exclusively without the occurrence of intervening or intermediate steps. The process depicted in the example depicted is implemented by encoder circuitry or processing circuitry in a transmitter such as, for example, in a base station. For simplicity, this disclosure will be described in the context of an example scenario in which the decoder 600 implements the PC-LDPC decoding process 701.

In block 755, the TQC-LDPC MAP decoder 600 receives a PC-LDPC convolutional code in a form of an H-matrix. The PC-LDPC convolutional code can be punctured or un-punctured. The H-matrix includes a systematic submatrix (H_{sys}) of the input systematic data and a parity check submatrix (Hₚₐᵣ) of parity check bits. The PC-LDPC convolutional code is characterized by a lifting factor (Z). The Hₚₐᵣ includes a column of Z-group parity bits concatenated with each column of systematic bits, and the Hₚₐᵣ includes J parity bits per systematic bit.

In blocks 760-775, the decoder decodes the received PC-LDPC convolutional code 610 into and a group (x_{z}(n)) 635 of Z systematic bits. The decoder performs blocks 760-775 for each Z-row of the PC-LDPC convolutional code 610.

In block 760, the TQC-LDPC MAP decoder 600 determines, from the PC-LDPC convolutional code, a specific quasi-cyclical domain of the Z-row that is different from any other quasi-cyclical domain of another Z-row of the PC-LDPC convolutional code.

In block 765, the TQC-LDPC MAP decoder 600 selectively quasi-cyclically shifts the bits of the Z-row by the specific quasi-cyclical domain. That is, the decoder 600 selects to omit quasi-cyclically shifting the bits of a first Z-row based on a determination that the first Z-row is all cyclical shifts of zero. Otherwise, the decoder 600 selects to perform the quasi-cyclically shifting of the bits of the first Z-row.

In block 770, the TQC-LDPC MAP decoder 600 performs Z parallel MAP decoding processes on the shifted bits of the Z-row.

In block 775, the TQC-LDPC MAP decoder 600 un-shifts the parallel decoded bits of the Z-row by the specific quasi-cyclical domain, yielding the group (x_{z}(n)) of Z systematic bits.

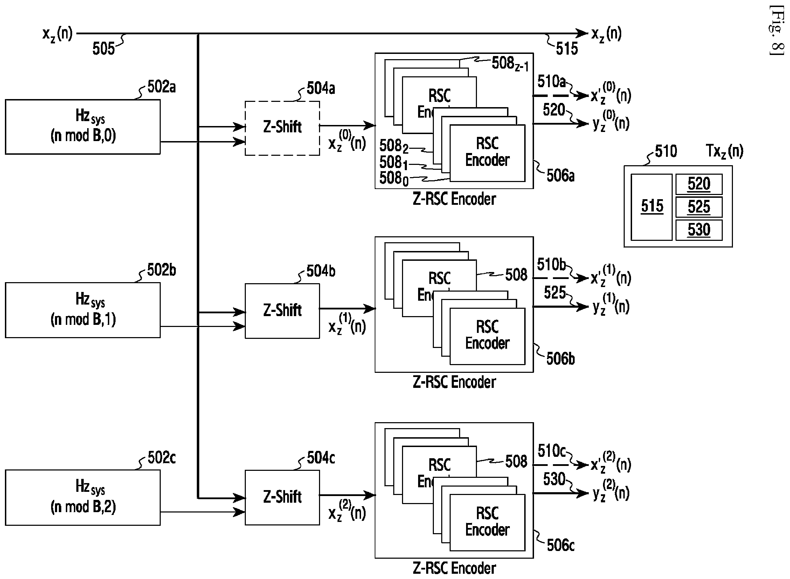

FIGURE 8 illustrates the QC-RSC encoder 500 of FIGURE 5 in more detail according to this disclosure. The example of QC-RSC encoder 500 has an underlying parity check matrix (PCM) H with J=3 Z-rows. The QC-RSC encoder 500 includes a set of J row identifiers 502a to 502c (generally referred to by reference number 502), namely, one row identifier per Z-row of the underlying PCM H, wherein each row identifier stores ${H}_{{z}_{sys}}^{T} \left(n mod B,j\right)$. The first Z-row identifier 502a stores ${H}_{{z}_{sys}}^{T} \left(n mod B,0\right)$; the second Z-row identifier 502b stores ${H}_{{z}_{sys}}^{T} \left(n mod B,1\right)$; and the third Z-row identifier 502a stores ${H}_{{z}_{sys}}^{T} \left(n mod B,2\right)$.

The QC-RSC encoder 500 includes a set of J quasi-cyclic shifters 504a to 504c (generally referred to by reference number 504), namely, one quasi-cyclic shifter per Z-row of the underlying PCM H. Each quasi-cyclic shifter 504 includes a multiplier that outputs the product of its two input values. That is, each quasi-cyclic shifter 504 receives the input 505 x_{z}(n), receives input ${H}_{{z}_{sys}}^{T} \left(n mod B,j\right)$. from the row identifier 502a to 502c of a corresponding Z-row, and outputs ${x}_{z}^{\left(j\right)} \left(n\right)$. The first quasi-cyclic shifter 504a outputs ${x}_{z}^{\left(0\right)} \left(n\right)$; the second quasi-cyclic shifter 504a outputs ${x}_{z}^{\left(1\right)} \left(n\right)$; and the third quasi-cyclic shifter 504a outputs ${x}_{z}^{\left(2\right)} \left(n\right)$.

The QC-RSC encoder 500 includes a set of J Z-RSC encoders 506a to 506c (generally referred to by reference number 506), namely, one Z-RSC encoder per Z-row of the underlying PCM H. Each Z-RSC encoder 506 includes a Z-RSC encoder set, namely, a group of Z RSC encoders 508 (individually referred to by reference numbers 508₀, 508₁, 508₂, ..., 508_{Z-1}) that encode the input bit set ${x}_{z}^{\left(j\right)} \left(n\right)$ through the j-th Z-RSC encoder set. In an example where the lifting factor is Z=42, the first Z-RSC encoder 506a includes 42 RSC encoders 508 within a first Z-RSC encoder set; the second Z-RSC encoder 506b includes 42 RSC encoders 508 within a second Z-RSC encoder set; and the third Z-RSC encoder 506c includes 42 RSC encoders 508 within a third Z-RSC encoder set. Each Z-RSC encoder 506 receives an input, which is the output ${x}_{z}^{\left(j\right)} \left(n\right)$ from a quasi-cyclic shifter 504 of a corresponding Z-row. Each Z-RSC encoder 506 outputs a Z-group of parity bits ${y}_{Z}^{\left(j\right)} \left(n\right)$ corresponding to its Z-row. More particularly, the first, second, and third Z-RSC encoders 506a, 506b, and 506c respectively output the first second and third Z-group of parity bits 515, 520, and 525. Each Z-RSC encoder set 506 consists of Z identical RSC encoders, where each RSC encoder 508 encodes a single bit (out of the Z input bits) at a time. That is, each Z-RSC encoder 506 is configured to encode Z input bits in parallel (i.e., at the same time), wherein each RSC encoder 508 encodes one of the Z input bits. That is, each Z-RSC encoder 506 provides a different input bit from the Z input bits of ${x}_{z}^{\left(j\right)} \left(n\right)$. to a different RSC encoder 508.

In a non-limiting example, the first, second, and third row identifiers 502 respectively provide a value of 30, 21, and 41 to its corresponding shifter 504. The first Z-RSC encoder 506a provides the first bit of ${x}_{z}^{\left(0\right)} \left(n\right)$ to the thirtieth RSC encoder 508₂₉, provides the twelfth bit of ${x}_{z}^{\left(0\right)} \left(n\right)$ to the forty-second RSC encoder 508₄₁, and provides the thirteenth bit of ${x}_{z}^{\left(0\right)} \left(n\right)$ to the first RSC encoder 508₀. In the 30^{th} permutation matrix of a set of 42 permutation matrices, the last row includes a value at the twelfth bit, which corresponds to the difference between the lifting factor (Z=42) and the value (n=30) output from the first row identifier 502a, and thus the first row includes a value at the thirteenth bit. The second Z-RSC encoder 506b provides the first bit of ${x}_{z}^{\left(1\right)} \left(21\right)$ to the twenty-first RSC encoder 508₂₀. The third Z-RSC encoder 506c provides the first bit of ${x}_{z}^{\left(1\right)} \left(41\right)$ to the forty-first RSC encoder 508₄₀.

According to REF12, y=E(x) where y and x are the output and input of a single bit Recursive Systematic Convolutional (RSC) encoder, respectively. As described above, each RSC encoder 508 receives one row of the quasi-cyclically shifted input, which includes one bit. Accordingly, the output ${y}_{z}^{\left(j\right)} \left(n\right)$ of an Z-RSC Encoder 506 can be expressed as ${{E}_{z}}^{\left(j\right)} \left({x}_{z}^{\left(j\right)}\left(n\right)\right)$. The j-th set of Z convolutional encoders E(x) corresponds to input ${x}_{z}^{\left(j\right)} \left(n\right)$, where the j-th convolutional encoder set corresponds to the j-th Z-row in ***H_{zsys}*** matrix out of J Z-rows. Hence, the j-th Z-group output parity bit set ${y}_{z}^{\left(j\right)} \left(n\right)$ is defined by Equation 5:
${y}_{z}^{\left(j\right)} \left(n\right) = {{E}_{z}}^{\left(j\right)} \left({x}_{z}^{\left(j\right)}\left(n\right)\right)$

The systematic set x_{z}(n) of the input 505 is the output 515 from the QC-RSC encoder 500 unchanged, as performed in other systematic codes (e.g., QC-LDPC codes and Turbo codes[0039]) (described in REF12). Alternatively, the encoder 500 can output a cyclically shifted Z-RSC systematic output set 510a, 510n, or 510c instead of outputting the unchanged set 515. The systematic output set $x {′}_{x}^{\left(j\right)} \left(n\right)$ can be derived from any of the cyclically shifted Z-RSC systematic output sets $x {′}_{z}^{\left(j\right)} \left(n\right)$ ,j=0,...,J-1=2. The output set $x {′}_{z}^{\left(j\right)} \left(n\right)$ is significant in the case of terminated codes during tail bit period, where each RSC encoder 508 outputs its tail information to enable proper code termination (e.g., reaching state "0"). The parity bit set ${y}_{z}^{\left(j\right)} \left(n\right)$, j=0,... ,J-1=2 is obtained from the quasi-cyclic shifted input set ${x}_{z}^{\left(j\right)} \left(n\right)$ to the j-th Z-RSC encoder set. The quasi-cyclic shift value for ${x}_{z}^{\left(j\right)} \left(n\right)$ is obtained from the corresponding Z-row j of the underlying PCM systematic part ***H_{zsys}***. In the case of non-existent shift value in the underlying PCM where ***H_{zsys}***(*j*, *l*) = -1, no encoding is performed for the corresponding input set x_{z}(n). In such embodiments, the first Z-row cyclic shift operation 504a can be omitted (shown by the dashed line) if the underlying PCM first row is all 0 values. Zero values denote un-shifted identity sub-matrices.

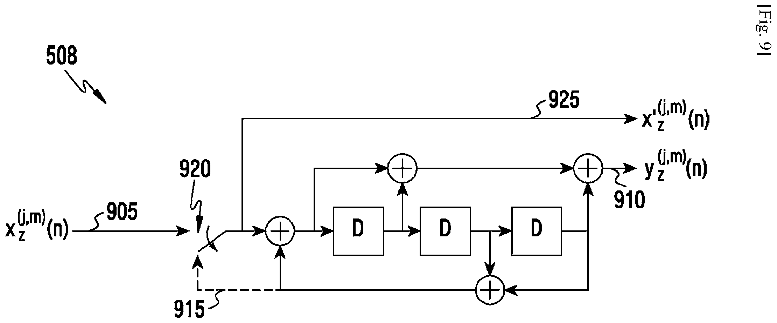

FIGURE 9 illustrates a Recursive Systematic Convolutional (RSC) encoder 508 according to this disclosure. The embodiment of the RSC encode 508 shown in FIGURE 9 is for illustration only. Other embodiments could be used without departing from the scope of the present disclosure.

The example of RSC encoder 508 corresponds to a constraint length of λ = 4. The RSC encoder 508 provides an output 910 that corresponds to a single input bit 905 ${x}_{z}^{\left(j, m\right)} \left(n\right)$, *m ∈* {0, ... , *Z -* 1} from the n-th Z-group of cyclically shifted input bit set ${x}_{z}^{\left(j\right)} \left(n\right)$ when passed through the m-th RSC encoder 508 in the j-th Z-RSC encoder set 506. The dotted line depicted represents the tail bits 915 processing at the end of the block in case of a finite stream. In this case, the input bits to the RSC encoder are disconnected (shown by opening of the switch 920), while the RSC encoder shift register is flushed and the outputs of both $x {′}_{z}^{\left(j, m\right)} \left(n\right) 925$ and ${y}_{z}^{\left(j, m\right)} \left(n\right) 9 10$ are sent to the corresponding decoder 600. The purpose of the tail bits 915 is to "bring" the finite state of the RSC encoder 508 to the all "0" state. The all "0" state at the end of the block encoding process allows the decoder 600 to terminate at a specified state (i.e., specified to both encoder 500 and decoder 600) at the end of the block.

The RSC encoder 508 uses the various polynomials expressed by Equations 6-8 to perform encoding.$G \left(D\right) = \left[1, \frac{{g}_{1} \left(D\right)}{{g}_{0} \left(D\right)}\right]$ ${g}_{0} \left(D\right) = 1 + {D}^{2} + {D}^{3}$ ${g}_{1} \left(D\right) = 1 + D + {D}^{3}$

The polynomials g₁(D) and g₀(D) are the feed-forward polynomial (numerator) and the feedback polynomial (denominator) respectively of an individual RSC encoder 508. Equations 9 and 10 express the individual RSC encoder polynomials, where ${g}_{0}^{\left(k\right)}$ and ${g}_{1}^{\left(k\right)}$ are the k-th location in the binary vector (of length λ) representation (over GF(2)) of g₀(D) and g₁(D) respectively, and λ is the constraint length (CL) of the code. Therefore, the RSC encoded parity bits, yᵢ, can be generated from input information bits, xᵢ, as ${y}_{i} = E \left({x}_{i}\right) = {\sum }_{k = 0}^{λ - 1} {g}_{1}^{\left(k\right)} {a}_{i - k} , {a}_{i} = {\sum }_{l = 0}^{λ - 1} {g}_{0}^{\left(l\right)} {x}_{i - l}$. Each polynomial has a degree λ-1 with ${g}_{i}^{\left(λ-1\right)} = 1$, *i* = 0,1 and ${g}_{i}^{\left(0\right)} = 1$ *i* = 0,1 which corresponds to the current input bit. Otherwise, the effective degree (thus constraint length) is reduced. An example of an RSC encoder polynomial, G(D), obtained from Long Term Evolution (LTE) Standard (See REF4) with constraint length λ =4${g}_{0} \left(D\right) = {\sum }_{k = 0}^{λ - 1} {g}_{0}^{\left(k\right)} {D}^{k}$ ${g}_{1} \left(D\right) = {\sum }_{k = 0}^{λ - 1} {g}_{1}^{\left(k\right)} {D}^{k}$

Although ensuring a specified state at the end of the block results in a marginal rate reduction, it reduces the decoding BER/FER compared to an unterminated code. As described more particularly below, a sliding window decoding method associated with the PC-LDPC convolutional codes does not require code termination to obtain a low BER. The input granularity, δ, to the QC-RSC encoder 500 is retained as δ=Z bits and the output rate of the unterminated TQC-LDPC RSC Encoder is R_{base} =(1+J)⁻¹. The output rate can be increased through puncturing, as shown in FIGURES 15 and 17.

FIGURE 10 illustrates an example of a Spatially-coupled Low Density Parity Check (SC-LDPC) base code according to this disclosure. The embodiment of the SC-LDPC base code 1000 shown in FIGURE 10 is for illustration only. Other embodiments could be used without departing from the scope of the present disclosure.

The capacity-approaching spatially-coupled (SC) LDPC code can be designed based on the process described in REF2. The encoder 500 transforms the designed SC-LDPC base code 1000 to a PC-LDPC convolutional code. The transformation to a trellis-based code enables use of trellis-based encoders, such as the QC-RSC encoder 500 along with the associated capacity-approaching trellis-based decoders, such as the MAP decoder 600.

The SC-LDPC code 1000 is derived from a (3,6) regular LDPC code through the process described in REF2. The encoder 500 selects the lifting factor of the code to be Z=42 (similar to IEEE802.11ad in REF8). The numbers in each entry denote the quasi-cyclic shift of the corresponding identity sub-matrix of size Z×Z. For example, '12' in an entry for I₀ means that the quasi-cyclic shift is 12.

The encoder 500 constructs the SC-LDPC code 1000 to include Systematic (I) and Parity (P) pairs. For every set of Z=42 input systematic bits, there are equal number of parity bits added to obtain the final codeword resulting in a code rate R=1/2. For the first set of Z=42 input systematic bits, the first Z-row is employed to generate the first set of parity bits. Then, for the second set of Z=42 input systematic bits, the second Z-row is employed to generate the second set of parity bits. For the third set of Z=42 input systematic bits, the third Z-row is employed to generate the third set of parity bits. The first Z-row is employed again for the fourth set of input systematic bits, and so on for the rest of the input sets. Note that although any parity set is obtained using a certain Z-row, it is then used in all Z-rows together with the corresponding systematic bits to obtain the next sets of parity bits. The row weight Wr of the SC-LDPC code 1000 is maintained at 6, and the maximum column weight Wc equals 3, although not all the columns have this weight. For example, the column weight of the first and last I/P pairs {I₀,P₀} and {I₄,P₄} equals 1; the column weight of the second and penultimate I/P pairs {I₁,P₁} and {I₃,P₃} equals 2; and the column weight of the middle I/P {I₂,P₂} is 3. The SC-LDPC code 1000 is characterized as a (3,6) base LDPC code corresponding to the (Wc,Wr). As discussed more particularly below, the SC-LDPC code 1000 (which is identical to each of the base codes 1000a to 1000d of FIGURES 12 and 13A) can include significant parity 1005, 1010, 1015 at least at the following (row, column) locations: (0, P₂) and (1, P₃) and (1, P₄).

FIGURE 11 illustrates another example of an SC-LDPC base code 1100 according to this disclosure. The systematic bits of the SC-LDPC base code 1100 correspond to the modified TQC-LDPC convolutional code 1400 in FIGURE 14. The parity bits are represented by number signs (#), as the parity bits are excluded as part of the transformation of the SC-LDPC base code 1100 to the modified TQC-LDPC convolutional code 1400.

FIGURE 12 illustrates a transformation of an SC-LDPC base code to an SC-LDPC code, to a serialized SC-LDPC code, to a concatenated SC-LDPC encoding structure according to this disclosure. The embodiment of the transformation shown in FIGURE 12 is for illustration only. Other embodiments could be used without departing from the scope of the present disclosure.

In part (a) of FIGURE 12, the encoder 500 repeats the SC-LDPC base code 1000 to construct a final (3,6) SC-LDPC code PCM H 1200. The base code repetition is performed to generate the parity bit sets for the next systematic bit sets. For the SC-LDPC base code 1000, the first Z-row of the second base code 1000b (non-shaded) is positioned to start on the 7^{th} column to form a continuation to the first Z-row of the first base code 1000a (faintly shaded). The first Z-row of the third base code 1000c (darkly shaded) is positioned to started on the 13^{th} column to form a continuation to the first Z-row of the second base code 1000b. The first Z-row of the fourth base code 1000d (lightly shaded) is positioned to started on the 19^{th} column to form a continuation to the first Z-row of the third base code 1000c.

The SC-LDPC code PCM H 1200 is a regular LDPC code with Wr=6 and Wc=3 for all rows and columns, respectively. The generated SC-LDPC code 1200 can be terminated on both sides as described in REF2. In other words, where k represents Wc and n represents Wr, a (k,n) regular SC-LDPC code of block size N and lifting factor Z, then the number, N_{ZRowSC}, of the unterminated PCM H Z-rows is defined by Equation 11:
${N}_{{ZRow}_{SC}} = \frac{\left(1-\frac{k}{n}\right) N}{Z} = \frac{\left(n-k\right) N}{nZ}$

The (k,n) SC-LDPC code 1200 has a repetition period every n columns with alternating systematic and parity columns (B=n/2 ). Since H is a block diagonal matrix, the first trellis-based transformation step is to serialize H. The serialization process reduces the effective number of Z-rows in the modified parity check matrix, to only J=k Z-rows in the serialized LDPC code parity check matrix. The modified PCM H' is obtained by adding the underlying H row sets as defined in Equation 12:
$H {′}_{{z}_{sys}} \left(j, l\right) = {\sum }_{S = 0}^{\frac{{N}_{{ZRow}_{SC}}}{k} - 1} {H}_{{z}_{sys}} \left(sk+j,l\right) , j ∈ \left\{0,…,J-1\right\} , l ∈ \left[-∞,∞\right]$

In part (b) of FIGURE 12, the encoder 500 performs (3,6) SC-LDPC code serialization 1201. Part (b) of FIGURE 12 shows the result of the serialization and the concatenation process on the (3,6) SC-LDPC code 1000.

The (k,n) SC-LDPC code is a regular code with quasi-cyclic value repetition period every n columns with alternating systematic and parity columns. The encoder 500 can expand the code beyond the N columns of the underlying SC-LDPC by concatenating H 1200 to obtain the streaming form of the concatenated SC-LDPC code. Even though the block diagonal parity check matrix H 1200 of the (3,6) SC-LDPC block code 1000 was transformed to a streaming code, the SC-LDPC encoding structure is maintained. That is, the code 1201 is not yet considered a trellis-based code because each parity bit depends on previous parity bits generated in other rows. For example, the parity bits calculated in the first row are dependent on three previous systematic bits and two previous parity bits from the two other rows.

In part (c) of FIGURE 12, the encoder 500 constructs a concatenated (3,6) SC-LDPC Encoding Structure 1202.

The significant parity generated in each row from prior (n-1) columns is shown. The significant parity of the first row are in columns 5, 11, 17, and 23; significant parity of the second row are in columns 7, 13, 19, and 25; and the significant parity of the third row are in columns 9, 15, 21, and 27. That is, each base code 1000a to 1000d includes significant parity for each row. Once the (3,6) streaming SC-LDPC code is obtained, the encoder converts the code 1201 to a trellis-based LDPC convolutional code 1202. The encoder 500 first separates the systematic portion (I) and the parity portion (P) of the streaming PCM. The systematic bits are then concatenated together while generating the parity bits. The parity bit sets are then modified to be generated from convolutional encoding (i.e., RSC encoder 508) to derive the final Parallel Concatenated TQC-LDPC (PC-LDPC) convolutional code. The derived PC-LDPC convolutional code has a fine input granularity, δ, which is defined as the minimum number of input information bits the code requires to generate a codeword, and equals to Z.

FIGURE 13 illustrates a process 1300 of generating a column of parity bits for a PC-LDPC convolutional code having an output rate of 1/2 from a concatenated SC-LDPC encoding structure having a separation of systematic bits from parity bits according to embodiments of this disclosure. The embodiment of the process 1300 shown in FIGURE 13 is for illustration only. Other embodiments could be used without departing from the scope of the present disclosure.

FIGURE 13A illustrates the trellis-based LDPC convolutional code 1202, where non-significant parity bits are marked (darkly shaded) for exclusion from the PC-LDPC convolutional code. For example, each base code 1000a to 1000d within coder 1202 excludes the non-significant parity bits. The encoder 500 extracts each column of the concatenated (3,6) SC-LDPC Encoding Structure 1202 that actually exhibits the full column weight Wc=3 and concatenates the extracted columns to construct the systematic bit set 1305. The encoder 500 generates a column of parity 1350 for each row of the systematic bit set 1305.

FIGURE 13B illustrates an example of the derived PC-LDPC convolutional code once the systematic bits are concatenated. A Z-column of parity bit set is attached to every Z-column of systematic bit set, creating a code rate R=1/2 through convolutional encoding (with constraint length of λ=4). Both the systematic and parity quasi-cyclic values are retained the same as the underlying (3,6) SC-LDPC code with Z=42.

The horizontal arrow 1310a to 1310c of each row spans λ=4 columns, which represents the PC-LDPC encoding operation of wherein 3 (i.e., n-1, where n=4) previous systematic values are used to generate the parity of n^{th} column. For example, in the first row, [0 12 0] systematic values are used to generate the parity [0] of the 4^{th} column; in the second row, [0 21 0] systematic values are used to generate the parity [0] of the 4^{th} column; and in the third row, [0 6 0] systematic values are used to generate the parity [0] of the 4^{th} column.

The each encoding process horizontal arrow 1310a to 1310c corresponds to a vertical arrow 1315a to 1315c of the parity of n^{th} column. The vertical arrow 1315a to 1315c represents the encoder 500 generating the parity 1320a to be concatenated with the systematic values.

FIGURE 14 illustrates a process 1400 of generating a column of parity bits for a modified TQC-LDPC convolutional code having an output rate of ⅓ according to embodiments of this disclosure. The embodiment of the process 1400 shown in FIGURE 14 is for illustration only. Other embodiments could be used without departing from the scope of the present disclosure. Note, the encoding function represented by the horizontal lines 1310a to 1310c and vertical lines 1320a to 1320c for generating parity 1320a to 1320c per column 1350 can be the same as or similar to the encoding function represented by the horizontal lines 1410a to 1410d and vertical lines 1420a to 1420d for generating parity 1420a to 1420d per column 1450.

Once the PC-LDPC convolutional code 1305 is derived from the SC-LDPC code 1000, the quasi-cyclic values may be altered to reduce the BER. An example of the modified quasi-cyclic values, while retaining the lifting factor, Z=42, is provided in FIGURE 14. The new quasi-cyclic values [30 6 28] replace the [0 12 0] values and apply to the corresponding systematic sets as well as the parity sets (same quasi-cyclic shift values). Different quasi-cyclic shift values can be applied for the corresponding systematic sets and parity sets. However, choosing different shift values increases the encoder and decoder complexities. The repetition rate (or periodicity) of B=3 of Z-group systematic bit sets is retained as the underlying SC-LDPC code systematic periodicity. A similar TQC-LDPC convolutional conversion method can also be applied to other rates. In certain embodiments, encoder 500 uses the modified TQC-LDPC convolutional code 1405 to output one parity 1415a to 1415c per column (i.e., $\left[\begin{matrix}30 & ⋅ & ⋅ \\ ⋅ & 29 & ⋅ \\ ⋅ & ⋅ & 31\end{matrix}\right]$), yielding a rate R=1/2. In other embodiments, the encoder uses the modified TQC-LDPC convolutional code 1405 to output an additional parity 1420d per column (i.e., $\left[\begin{matrix}30 & 6 & . \\ . & 29 & 32 \\ 41 & . & 31\end{matrix}\right]$), yielding a modified PCM with R=1/3. The R=1/3 TQC-LDPC convolutional PCM retains the structure of the R=1/2 PCM, however, twice as many parity bits as in the case of R=1/2 code are output from the encoder 500 at a time.

In the systematic bit set 1405 of FIGURES 14 and 15, the code periodicity B=3 is retained throughout the transformation. Similar to block codes where increasing the block size can lead to BER reduction, even in TQC-LDPC convolutional codes (i.e., PC-LDPC convolutional codes); increasing B reduces the periodicity and can further reduce the BER of the code. Example methods to increase B include: the single step PC-LDPC encoding method 700 without blocks 740 or 745, the dual-step PC-LDPC encoding method 700 with block 745, and the PC-LDPC encoding method 700 including the permutation method of block 740. The single step PC-LDPC encoding method 700 increases the number of Z-columns compared to the underlying LDPC systematic parity check matrix (*H_{Zsys})*.

FIGURE 15 illustrates a process 1500 of puncturing by applying a puncturing pattern to the modified TQC-LDPC convolutional code having an output rate of ½ of FIGURE 14 according to embodiments of this disclosure.

The encoder 500 implements a method of reducing BER by performing puncturing wherein the third row is not used for R=1/2. For example, the column 1550 of parity output from the encoder 500 has two rows instead of three. Instead of using the nth row of systematic bits [31 41 24] to generate parity for the nth row, the encoder 500 uses the n-1 systematic bits [32 21 29] of the second row to generate the third parity 1520.

FIGURE 16 illustrates a process 1600 of reducing periodicity while generating a column of parity bits for an example modified TQC-LDPC convolutional code having an output rate of 1/3 according to embodiments of this disclosure. The embodiment of the process 1600 shown in FIGURE 16 is for illustration only. Other embodiments could be used without departing from the scope of the present disclosure.

The encoder 500 can increase the periodicity beyond B=3 to a higher value (e.g., B=6 and beyond) to further reduce the BER. For example, similar to the systematic bit set 1305 having B=3, the systematic bit set 1605 having B=3. Increasing B also increases the Z-Shift complexity since it increases the number of shifting options for each Z-row. According to REF13, increasing the shifting options increases the encoder/decoder critical path latency and die area, which reduces the throughput and increases power consumption respectively. The input granularity δ remains Z.

FIGURE 17 illustrates a process 1700 of reducing periodicity and puncturing by applying a puncturing pattern to the modified TQC-LDPC convolutional code of FIGURE 16 having an output rate of ½ according to embodiments of this disclosure. The process 1700 is similar to the process 1500 of FIGURE 15.

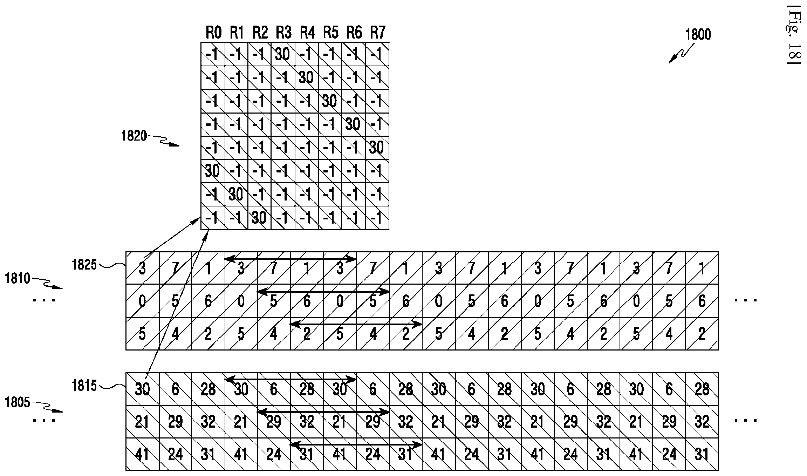

FIGURE 18 illustrates a Dual-Step PC-LDPC convolutional code 1800 according to embodiments of this disclosure. The embodiment of the Dual-Step PC-LDPC convolutional code 1800 shown in FIGURE 18 is for illustration only.

In REF5, an algorithm (namely Dual-Step) is proposed for deriving an LDPC block code family with code length Zp×N, where N is the base-family LDPC block code-length and Zp is a second level (step) lifting factor, over the original Z lifting factor, that is applied to the base-family to increase the block size. The algorithm in REF5 preserves the properties of the base-family: the new LDPC code family inherits its structure, threshold, row weight, column weight, and other properties from the base-family. In addition, the number of non-zero elements in the new codes increases linearly with Zp, however, the decoding complexity per bit remains the same. The Zp Quasi-Cyclic shift method 1800 expands the Z sets Zp times by applying a second level of Zp cyclic shifts. As an example of Zp=8, the encoder 500 applies the Zp Dual-Step Quasi-Cyclic Shift method 1800 to the TQC-LDPC convolutional code.

Each entry in the base PCM 1805 is lifted (or expanded) by Zp=8. The values in the upper matrix 1810 denote the cyclic right shift to be applied to the base PCM entry. In this example, the PCM entry 1815 having a value of "30" is lifted again by the second level lifting factor Zp=8 of the matrix 1820 and is cyclically shifted by the corresponding entry 1825 having a value of "3". That is, the entries 1815 and 1825 correspond to each other by having a same location within their respective matrices 1805 an 1810. Hence the dual-step method input granularity requirement is δ_{DS}=Zp×Z.

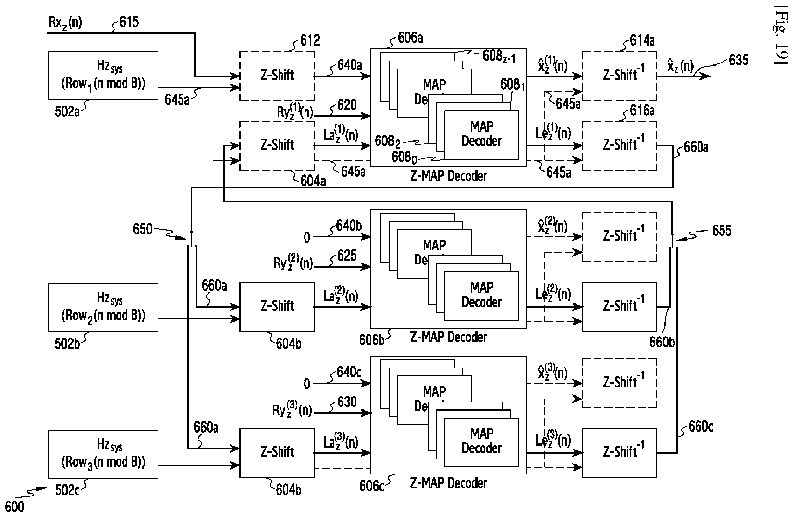

FIGURE 19 illustrates the TQC-LDPC MAP decoder 600 of FIGURE 6 in more detail according to this disclosure. The QC-MAP decoder architecture 600 includes a set of J row identifiers 502a to 502c identical to the row identifiers of the encoder 500. The first row includes two quasi-cyclic shifters 604a and 612 that each receives the same input (i.e., a value of n) from the corresponding row identifier 502a of the first row. The shifter 612 outputs Z soft decision LLRs 640a for each bit of the input 615. During a first iteration, prior to inputting any information into the Z-MAP decoder 606a, the shifter 604a is configured to output an a-priori LLR of decoded bits ${La}_{Z}^{\left(1\right)} \left(n\right)$ based on an a null input. For each iteration (i.e., excluding the first iteration), the shifter 604a forwards the quasi-cyclic shift value 645a from the row identifier 502a to corresponding un-shifters 616a and 614a of the same row. The QC-MAP decoder architecture 600 includes a set of J Z-MAP decoders 606a-606c, each of which includes a Z-MAP decoders 608 (individually referred to by reference numbers 608₀, 608₁, 608₂, ..., 608_{Z-1}). Each Z-MAP decoder 608 receives three inputs 640a, 620, and ${La}_{Z}^{\left(j\right)} \left(n\right)$ and generates two outputs, namely, a decoded version of the received 615 information x and a set of Z extrinsic LLR values ${Le}_{Z}^{\left(j\right)} \left(n\right)$ corresponding to each a-priori bit ${La}_{Z}^{\left(j\right)} \left(n\right)$. The un-shifters 614a, 616a reverse the quasi-cyclic shift that occurred in the shifters 612 and 604, respectively.

Each other row includes one quasi-cyclic shifter 604a-604b that receives an input from a corresponding row identifier 502b and 502c. Each other row includes other components that function in a same or similar manner as the first row components. The switch 650 of the decoder 600 enable each other row to selectively (e.g., upon convergence of the ${\hat{x}}_{Z}^{\left(1\right)} \left(n\right)$ value with the ${Le}_{Z}^{\left(1\right)} \left(n\right)$ value) receive and decode a current un-shifted set of Z extrinsic LLR values Le_{Z}(n) 660a. The switch 655 of the decoder 600 enable each other row to selectively provide feedback of a set of Z extrinsic LLR values 660b, 660c to any other shifter 604a of a same or different row.

The QC-MAP decoder architecture 600 is based on the TQC-LDPC MAP (QC-MAP) decoder relations, which can be expressed by a set of equations including Equation (14). The first row Z-Shift 604 and 610 can be omitted if the first row of the PCM is all cyclic shifts of 0 (i.e., not shifted).

The decoder LLR input 610 is grouped similar to the encoder output 510, in Z-group LLRs of the systematic bit set, Rx_{z}(n) 615, and three corresponding parity bit sets, ${Ry}_{Z}^{\left(0\right)} \left(n\right) , {Ry}_{Z}^{\left(1\right)} \left(n\right) , {Ry}_{Z}^{\left(2\right)} \left(n\right)$. Each Z-MAP decoder 606a-606c set out of the three Z-MAP decoder sets processes the corresponding received LLR set input at different interleaved domain determined by the corresponding ***H_{zsys}*** Z-row. Each Z-MAP decoder set consists of Z parallel MAP decoders. As shown in FIGURE 13, a three sequential transmissions $\left\{\left[\begin{matrix}0 \\ 12 \\ 0\end{matrix} |\begin{matrix}0 \\ ⋮ \\ ⋮\end{matrix}\right], \left[\begin{matrix}0 \\ 21 \\ 0\end{matrix} |\begin{matrix}⋮ \\ 0 \\ ⋮\end{matrix}\right], \left[\begin{matrix}0 \\ 6 \\ 0\end{matrix} |\begin{matrix}⋮ \\ ⋮ \\ 0\end{matrix}\right]\right\}$ of the PC-LDPC convolutional code 510 are transmitted to the decoder 600. Accordingly, in the decoder, the received systematic LLR input set 615 is connected (either interleaved when the Z-Shift block 612 is not used, or non-interleaved when the Z-Shift block 612 is used) only to the top Z-MAP decoder set, while the systematic LLR input set 640b-640c to the other two Z-MAP decoders 606b-606c has 0 (undecided value in 2's complement) soft decision input value. The decoding scheduling between the Z-MAP decoders 606a-606c depends on the QC-RSC encoding transmitting order and puncturing. In the code example given in FIGURE 16 for final punctured R=1/3, the iterative QC-MAP decoder order can be: Z-MAP0, Z-MAP1, Z-MAP0, Z-MAP2, and so on.

The TQC-LDPC MAP decoder 600 is configured or designed to apply a MAP decoding technique to decode the PC-LDPC convolutional codes described above. Given that in the encoder 500 structure, each RSC encoder 508 is lifted by Z to obtain the Z-RSC encoder set 506, and each Z-RSC encoder set 506 processes the corresponding Z-group systematic bit set at a different quasi-cyclic domain. Similarly, the single bit MAP decoder, explained above, is likewise lifted by Z to obtain the Z-MAP decoder set which consists of Z parallel and independent (i.e., contention-free) single-bit MAP decoders. Each Z-MAP decoder set processes the Z-group encoded LLR set received from the channel at a different quasi-cyclic domain.

Hence, the decoder 600 applies the Z-lifting to the log-likelihood ratio in Equation 13 to derive the Z-MAP decoder set for the received encoded signal with rate R_{base} described above (assuming no puncturing). In Equation 13, *Lₐ*⁽⁰⁾(*uₖ*) = 0, *L_{c}*^{(*i*)} = (4*Eₛ*/*N*₀) for all MAP decoders with a systematic input (typically, only one MAP decoder has systematic input), and *L_{c}*^{(*i*)} = 0 for all other MAP decoders that have parity input only.$\begin{matrix}{{L}_{e}}^{\left(i\right)} \left({u}_{k}\right) = {L}^{\left(i\right)} \left({u}_{k}| \vec{r}\right) - {{L}_{c}}^{\left(i\right)} {r}_{{u}_{k}} - {{L}_{a}}^{\left(i\right)} \left({u}_{k}\right) \\ = {L}^{\left(i\right)} \left({u}_{k}| \vec{r}\right) - {{L}_{c}}^{\left(i\right)} {r}_{{u}_{k}} - {{L}_{e}}^{\left(i-1\right)} \left({u}_{k}\right) \\ = {\sum }_{t = 0}^{i} {\left(-1\right)}^{\left(t\right)} \left({L}^{\left(i-t\right)}\left({u}_{k}| \vec{r}\right)-{{L}_{c}}^{\left(i-t\right)}{r}_{{u}_{k}}\right)\end{matrix}$

The decoder 600 uses the same LDPC block code PCM H of either FIGURES 13B to 18 with lifting factor Z and J sets of Z rows (namely Z-rows) and B sets of Z systematic columns (namely systematic Z-columns). The row identifiers 502a to 502c are based on a specific row of the systematic submatrix of the input 610, namely, ***H_{zsys}*** (*j, l*) *j* = 0, ... , *J* - 1, *l* = 0, ... , *B -* 1, which is the systematic part of the j-th Z-row and l-th Z-column of the underlying LDPC block code H. The i-th sub-iteration Z-group LLR output set is defined as ${{L}_{z}}^{\left(i\right)} \left({x}_{z}^{\left(i mod J\right)}\left(n\right) |\vec{r}\right)$ and corresponds to the (i mod J)-th H Z-row quasi-cyclic shifted n-th Z-group information bit set encoder input ${x}_{z}^{\left(i mod J\right)} \left(n\right)$. The i-th sub-iteration Z-group intrinsic information vector set is defined as *L_{cz}*^{(*i*)}, where *L_{cz}*^{(*i*)} = (4*Eₛ*/*N*₀)1̅, wherein 1̅ is an all 1 vector of size Z for all the Z-MAP decoders with a systematic input, otherwise *L_{cz}*^{(*i*)} = 0̅ and 0̅ is an all 0 vector. Let Rx_{z}(n) be the n-th received Z-group systematic LLR set corresponding to n-th Z-group information bit set x_{z}(n) in the encoder output. Let ${{L}_{ez}}^{\left(i\right)} \left({x}_{z}^{\left(i mod J\right)}\left(n\right)\right)$ be the i-th sub-iteration Z-group extrinsic information set corresponding to ${x}_{z}^{\left(i mod J\right)} \left(n\right)$. In the case of non-interleaved systematic transmission, the iterative Z-MAP decoding recursive extrinsic equation for the i-th sub-iteration is expressed by Equation 14 as:
$\begin{matrix}{{L}_{ez}}^{\left(i\right)} \left({x}_{z}^{\left(i mod J\right)}\left(n\right)\right) {H}_{{z}_{sys}}^{- 1 \left(T\right)} \left(n mod B,i mod J\right) = \\ {\sum }_{t = 0}^{i} {\left(-1\right)}^{\left(t\right)} \left(\begin{matrix}{{L}_{z}}^{\left(i-t\right)} \left({x}_{z}^{\left(\left(i-t\right)mod J\right)}\left(n\right)| \vec{r}\right) {H}_{{z}_{sys}}^{- 1 \left(T\right)} \left(n mod B, \left(i-t\right) mod J\right) - \\ {{L}_{cz}}^{\left(i-t\right)} {Rx}_{z} \left(n\right)\end{matrix}\right)\end{matrix}$

In equation 14, ${H}_{{z}_{sys}}^{- 1 \left(T\right)}$ is the reverse transpose quasi-cyclic shift matrix such that: ${H}_{{z}_{sys}}^{- 1 \left(T\right)} \left(l, j\right) {H}_{{z}_{sys}}^{T} \left(l, j\right) = {I}_{Z}$, where I_{Z} is the z×z identity matrix, and *L_{ez}*⁽⁰⁾(*x_{z}*(*n*)) = *L_{az}*⁽¹⁾(*x_{z}*(*n*)) = 0. Alternatively, in the case of interleaved systematic transmission, the iterative Z-MAP decoding recursive extrinsic equation for the i-th sub-iteration is expressed by Equation 15:
$\begin{matrix}{{L}_{ez}}^{\left(i\right)} \left({x}_{z}^{\left(i mod J\right)}\left(n\right)\right) {H}_{{z}_{sys}}^{- 1 \left(T\right)} \left(n mod B,i mod J\right) = \\ {\sum }_{t = 0}^{i} {\left(-1\right)}^{\left(t\right)} \left(\begin{matrix}{{L}_{z}}^{\left(i-t\right)} \left({x}_{z}^{\left(\left(i-t\right)mod J\right)}\left(n\right)| \vec{r}\right) - \\ {{L}_{cz}}^{\left(i-t\right)} {Rx}_{Z}^{\left(\left(i-t\right)mod J\right)} \left(n\right)\end{matrix}\right) {H}_{{z}_{sys}}^{- 1 \left(T\right)} \left(n mod B, \left(i-t\right) mod J\right)\end{matrix}$
where ${Rx}_{z}^{\left(i mod J\right)} \left(n\right)$ is the n-th received Z-group interleaved systematic LLR set. Hence, we can define the recursive iterative relation between the extrinsic LLR information at sub-iteration i and the a priori LLR information at sub-iteration i+1 corresponding to Z-group information bit set x_{z}(n), as expressed in Equation (16):
$\begin{matrix}{{L}_{az}}^{\left(i+1\right)} \left({x}_{z}^{\left(\left(i+1\right)mod J\right)}\left(n\right)\right) {H}_{{z}_{sys}}^{- 1 \left(T\right)} \left(n mod B,\left(i+1\right)mod J\right) \\ {{L}_{ez}}^{\left(i\right)} \left({x}_{z}^{\left(i mod J\right)}\left(n\right)\right) {H}_{{z}_{sys}}^{- 1 \left(T\right)} \left(n mod B,i mod J\right)\end{matrix}$
which results in Equation 17:
$\begin{matrix}{{L}_{az}}^{\left(i+1\right)} \left({x}_{z}^{\left(\left(i+1\right)mod J\right)}\left(n\right)\right) = {{L}_{ez}}^{\left(i\right)} \left({x}_{z}^{\left(i mod J\right)}\left(n\right)\right) {H}_{{z}_{sys}}^{- 1 \left(T\right)} \left(n mod B,i mod J\right) \\ {H}_{{z}_{sys}}^{T} \left(n mod B,\left(i+1\right)mod J\right)\end{matrix}$

It can be verified that for non-interleaved PCM, where ${H}_{{z}_{sys}}^{- 1 \left(T\right)} \left(l, j\right) = {H}_{{z}_{sys}}^{T} \left(l, j\right) = {I}_{Z}$, the a priori LLR information at sub-iteration i+1 is equal to the extrinsic information at sub-iteration i, as expressed in Equation 18:
${{L}_{az}}^{\left(i+1\right)} \left({x}_{z}^{\left(\left(i+1\right)mod J\right)}\left(n\right)\right) = {{L}_{ez}}^{\left(i\right)} \left({x}_{z}^{\left(i mod J\right)}\left(n\right)\right)$

Equation 18 illustrates that the extrinsic information passing between the Z-MAP decoders 606 during each sub-iteration need to be de-interleaved first, and then re-interleaved prior to processing as a priori information in the next sub-iteration. Finally, the decoder output 635, ${\hat{x}}_{z}^{\left(i\right)} \left(n\right)$, at the i-th sub-iteration (for interleaved systematic transmission is expressed by Equation 19:
${\hat{x}}_{z}^{\left(i\right)} \left(n\right) = {{L}_{z}}^{\left(i\right)} \left({x}_{z}^{\left(i mod J\right)}\left(n\right)| \vec{r}\right) {H}_{{z}_{sys}}^{- 1 \left(T\right)} \left(n mod B,i mod J\right) = \left(\begin{matrix}{{L}_{e}}^{\left(i\right)} \left({x}_{z}^{\left(i mod J\right)}\left(n\right)\right) + \\ {{L}_{a}}^{\left(i\right)} \left({x}_{z}^{\left(i mod J\right)}\left(n\right)\right) + {{L}_{cz}}^{\left(i\right)} {Rx}_{z}^{\left(i mod J\right)}\end{matrix}\right) {H}_{{z}_{sys}}^{- 1 \left(T\right)} \left(n mod B,i mod J\right)$

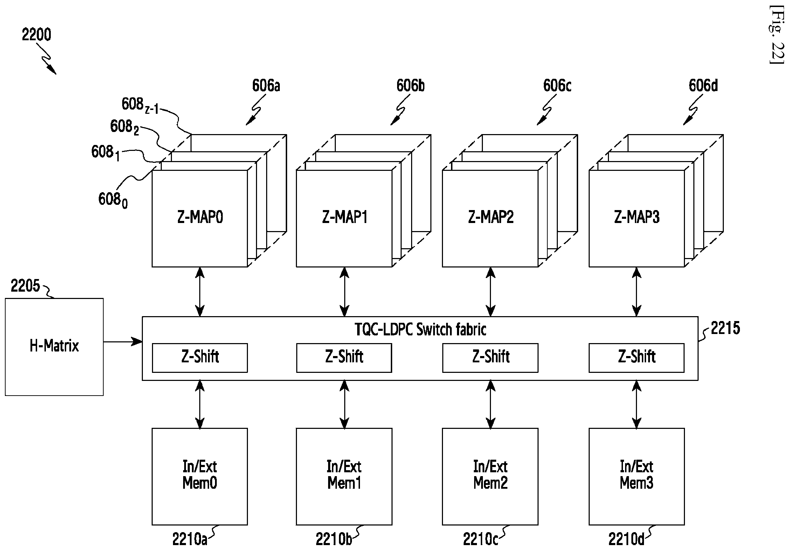

FIGURE 22 illustrates a block diagram of a Parallel Processing Z Maximum A posteriori Probability (Z-MAP) decoder 2200 according to this disclosure. The TQC-LDPC MAP decoder 600 of FIGURE 6 can include the decoder 2200 or can operate in a similar or same manner as the decoder 2200.

The Z-MAP decoder 2200 includes an H-Matrix 2205, M (for example, λ) Z-MAP decoders 606a-606d, M input/extrinsic memory modules 2210a-2210-d, and a TQC-LDPC switch fabric 2215. In the example shown, the Z-MAP decoder 2200 includes M=4 Z-MAP decoders 606a-606d, representing a Z-MAP decoder per column (for example, λ columns) of the H matrix input 610 to the decoder 2200 (e.g., decoder 600) or output 510 from the encoder 500.

The segmentation methods can also be applied to increase the throughput of overall block/window MAP decoding. The Z-MAP decoder 2200 provides a hierarchical segmentation of the block/window that is divided between multiple MAP decoders 608 working concurrently, wherein each MAP decoder can process one or more segments. Similar to the segmentation method, each of the parallel processing MAP decoders processes different segment of the block at a time thus no contention is occurred during the lambda (λ) memory accesses. The lambda memory can be also divided into segmented memories to support the increased throughput requirement.

The M=4 Z-MAP decoders 606a-606d are connected to the M=4 lambda memory modules 2210a-d through the TQC-LDPC Switch Fabric 2215. The TQC-LDPC Switch Fabric 2215 provides contention-free transfers between the input 610 and extrinsic memory and the Z-MAP decoders 606a-606d. The parity check matrix (namely, H-Matrix) 2205 controls the extrinsic transfers through the switch fabric 2215 in order to provide the contention-free transfers. The TQC-LDPC convolutional code structure fits the contention-free requirement for the parallel processing Z-MAP decoders because in all the interleaved domains (including the non-interleaved domain) the extrinsic information is interleaved only within the quasi-cyclic region (within the size of Z consecutive extrinsic information words). Hence, each Z-MAP decoder606a-606d and corresponding memory module 2210a-2210d can process a different region of the block/window separately. The only shared memory region required between two consecutive MAP decoders is a (beta) learning period. In certain embodiments, the Parallel Processing Z-MAP decoder 2200 can be optimized such that the TQC-LDPC Switch Fabric 2215 includes M Z-shift registers (such as the Z-Shift 604 or 612), each coupled between a corresponding pair of a Z-MAP decoder 606 and an input/extrinsic memory module 2210 (e.g., Z-MAP0 paired with In/Ext MemO).

Table 1 summarizes the various algorithms the can be implemented in the decoder 600 and 2200 according to this disclosure. Table 1 includes Log-MAP Decoding based on BCJR algorithm. These decoding algorithms are described above with reference to FIGURE 19 and Equations 13 to 19 and further discussed below.

| Algorithm type | Algorithm expressed Mathematically |
|---|---|
| Log-Likelihood Ratio (LLR) | Equation 20 |
| Forward Path Metric | Equation 23 |
| Backward Path Metric | Equation 24 |
| MAX* Definition | $\begin{matrix}{{max}_{i}}^{∗} \left({x}_{i}\right) = ln \left({\sum }_{i} exp \left({x}_{i}\right)\right) \\ = {x}_{j} + ln \left(1+{\sum }_{iJay} exp \left(-\left\|{x}_{i}-{x}_{j}\right\|\right)\right) ,\end{matrix}$ where *j* = *argmaxᵢ*(*xᵢ*) (as described with reference to Equation 25) |
| MAX* Log-MAP | $\begin{matrix}L \left({u}_{k} \|\vec{r}\right) = {{max}^{∗}}_{{\left(s′,s\right) \|}_{{u}_{k} = + 1}} \left(α{′}_{k - 1}\left(s′\right)+γ{′}_{k}\left(s′,s\right)+β{′}_{k}\left(s\right)\right) \\ - {{max}^{∗}}_{{\left(s′,s\right) \|}_{{u}_{k} = - 1}} \left(\begin{matrix}α {′}_{k - 1} \left(s′\right) + γ {′}_{k} \left(s′,s\right) \\ + β {′}_{k} \left(s\right)\end{matrix}\right)\end{matrix}$ (as described with reference to Equation 26) |
| MAX Log-MAP | Equation 28 |
| Scaled MAX (SMAX) Log-MAP (q=0.75) | ${L}_{e} \left({u}_{k}\right) = q \left(L\left({u}_{k} \|\vec{r}\right)-{L}_{c}{r}_{{u}_{k}}-{L}_{a}\left({u}_{k}\right)\right)$ Extrinsic Output LLR Intrinsic Apriori |

The Log-MAP decoder [0039]is a trellis-based decoder that processes the received LLR of the encoded bits in both forward and backward directions to generate both the extrinsic information and the LLR of the decoded bits. The extrinsic information can be used for iterative decoding. As an example αₖ₋₁ (s'),γₖ(s',s), and βₖ(s) represent respectively the feed-forward (ff) path metric of bit (k-1) at state s', the branch metric from state s' to state s and the feed-backward (fb) path metric of bit (k) at state s. For data transmission over a Additive White Gaussian Noise (AWGN) channel, the Log Likelihood Ratio (LLR) *L*(*uₖ* | *r̅*) of a code bit uₖ=xₖ for a given received AWGN perturbed encoded sequence $\vec{r} = \left\{…,{X}_{k},{Y}_{k}^{0},…,{Y}_{k}^{1 / R - 2},{X}_{k + 1},…\right\}$ (example for 1/RE{3,4,5,... }) can be expressed by Equation (20).$L \left({u}_{k} |\vec{r}\right) = ln \frac{{\sum }_{{\left(s′,s\right) |}_{{u}_{k} = + 1}} exp \left(α{′}_{k - 1}\left(s′\right)+γ{′}_{k}\left(s′,s\right)+β{′}_{k}\left(s\right)\right)}{{\sum }_{{\left(s′,s\right) |}_{{u}_{k} = - 1}} exp \left(α{′}_{k - 1}\left(s′\right)+γ{′}_{k}\left(s′,s\right)+β{′}_{k}\left(s\right)\right)}$
where α'ₖ₋₁(s'),γ'ₖ(s',s),β'ₖ(s) are the exponent terms of αₖ₋₁(s'),γₖ(s',s),βₖ(s), respectively (i.e., α'ₖ₋₁(s')=ln(αₖ₋₁(s'))+C where C is dependent on the AWGN variance). The sum in the numerator is over all state transitions s' to s with a decision uₖ=+1, and the sum in the denominator is over all state transitions s' to s with a decision uₖ=-1. In the case of AWGN, the feed-forward path metric αₖ(s) and the feed-backward path metric βₖ(s) are directly proportional (in LLR calculations all constant terms are eliminated) to the sum of exponents of the candidate path metrics leading to state s from state s' and state s", respectively, as expressed in Equations 21 and 22.${α}_{k} \left(s\right) ∝ exp \left(α{′}_{k}\left(s\right)\right) = {\sum }_{i} exp \left(α{′}_{k - 1}\left({s}_{i}′\right)+γ{′}_{k}\left({s}_{i}′,s\right)\right)$ ${β}_{k} \left(s\right) ∝ exp \left(β{′}_{k}\left(s\right)\right) = {\sum }_{i} exp \left(β{′}_{k + 1}\left({s}_{i}"\right)+γ{′}_{k}\left(s, {{s}_{i}}^{"}\right)\right)$

Hence, α'ₖ(s) and β'ₖ(s) can be expressed according to Equations 23 and 24: $α {′}_{k} \left(s\right) = ln \left({\sum }_{i} exp \left(α{′}_{k - 1}\left({s}_{i}′\right)+γ{′}_{k}\left({s}_{i}′,s\right)\right)\right)$ $β {′}_{k} \left(s\right) = ln \left({\sum }_{i} exp \left(β{′}_{k + 1}\left({s}_{i}"\right)+γ{′}_{k}\left(s,{s}_{i}"\right)\right)\right)$

The max* operation can be applied to distinguish the maximum path metric from the other candidates in each state. The max* operation is defined according to Equation 25.${{max}^{∗}}_{i} \left({x}_{i}\right) ≜ ln \left({\sum }_{i} exp \left({x}_{i}\right)\right) = {x}_{j} + ln \left(1+{\sum }_{i \ j} exp \left(-\left|{x}_{i}-{x}_{j}\right|\right)\right)$
where j=argmaxᵢ(xᵢ). The max* operation can be applied to α'ₖ(s) and β'ₖ(s) for all possible ${s}_{i}^{′}$ and ${s}_{i}^{"}$ states respectively. The LLR *L*(*uₖ* | *r̅*) of the code bit uₖ as expressed in Equation 20 can be rewritten in max* log-MAP form as expressed in Equation 26. $\begin{matrix}L \left({u}_{k} |\vec{r}\right) = ln \left({\sum }_{{\left(s′,s\right) |}_{{u}_{k} = + 1}} exp \left(α{′}_{k - 1}\left(s′\right)+γ{′}_{k}\left(s′,s\right)+β{′}_{k}\left(s\right)\right)\right) - \\ ln \left({\sum }_{{\left(s′,s\right) |}_{{u}_{k} = - 1}} exp \left(α{′}_{k - 1}\left(s′\right)+γ{′}_{k}\left(s′,s\right)+β{′}_{k}\left(s\right)\right)\right) = \\ {{max}^{∗}}_{{\left(s′,s\right) |}_{{u}_{k} = + 1}} \left(α{′}_{k - 1}\left(s′\right)+γ{′}_{k}\left(s′,s\right)+β{′}_{k}\left(s\right)\right) - \\ {{max}^{∗}}_{{\left(s′,s\right) |}_{{u}_{k} = - 1}} \left(α{′}_{k - 1}\left(s′\right)+γ{′}_{k}\left(s′,s\right)+β{′}_{k}\left(s\right)\right)\end{matrix}$

Alternatively, the max operation can be employed in order to reduce the max* operation complexity by finding only the maximum path metric of all candidates in each state as expressed in Equation 27.${max}_{i} \left({x}_{i}\right) = {x}_{j}$
where, again, j=argmaxᵢ(xᵢ). The max operation can be applied to to α'ₖ(s) and β'ₖ(s) for all possible ${s}_{i}^{′}$ and ${s}_{i}^{"}$ states, respectively. The LLR of the code bit uₖ can then be written in max Log-MAP form as expressed in Equation 28:
$\begin{matrix}L \left({u}_{k}| \vec{r}\right) = \\ {max}_{{\left(s′,s\right) |}_{{u}_{k} = + 1}} \left(α{′}_{k - 1}\left(s′\right)+γ{′}_{k}\left(s′,s\right)+β{′}_{k}\left(s\right)\right) - {max}_{{\left(s′,s\right) |}_{{u}_{k} = - 1}} \left(\begin{matrix}α {′}_{k - 1} \left(s′\right) + γ {′}_{k} \left(s′,s\right) + \\ β {′}_{k} \left(s\right)\end{matrix}\right)\end{matrix}$

As mentioned above, the max operation has lower complexity than the max* operation, since the max operation excludes the correction function (10) that is typically implemented as a Look-Up Table (LUT). However, the reduced complexity of the max operation results in a higher BER/FER (-0.4-0.5 dB degradation). See REF6 and REF7. In REF6 a scaling factor q scales the extrinsic information values after each iteration, to mitigate the BER increase that occurs due to employing max operation (namely Scaled MAX Log-MAP) instead of the max* operation. Hence, the Scaled MAX Log-MAP extrinsic information LLR can be written as expressed in Equation 29:
${L}_{e} \left({u}_{k}\right) = q \left(L\left({u}_{k}| \vec{r}\right)-{L}_{c}{r}_{{u}_{k}}-{L}_{a}\left({u}_{k}\right)\right)$
where Lₐ(uₖ) is the a priori LLR of uₖ (for example, an a priori information from previous iteration extrinsic information), *rᵤₖ* is the received input systematic bit k and *L_{c}rᵤₖ* = (4*Eₛ*/*N*₀)*rᵤₖ* is the intrinsic information. In REF6 it is shown that q=0.7 provides less than 0.2 dB SNR degradation to maintain the same BER and Block Error Rate (BLER) as the Log-MAP. As an example, q=0.75 can selected or employed since it can be implemented using right shifts and addition operations instead of multiplications.

The branch metric γ'ₖ(s',s) can be written using the LLR expressions as in expressed in equation (30). (See REF7).$γ {′}_{k} \left(s′,s\right) = \frac{1}{2} {\hat{u}}_{k} {L}_{a} \left({u}_{k}\right) + \frac{1}{2} {L}_{c} {\vec{r}}_{k} ⋅ {\vec{v}}_{k}$
where *r̅ₖ* is the received input symbol (systematic and parity) vector, and *v̅ₖ* and *ûₖ* are the expected encoder output symbol (systematic and parity bits) vector and expected systematic bit respectively for transition from state s' to state s.

Accordingly, MAP decoding enables an iterative process. An iteration is defined as a processing cycle through a set of (non-repetitive) MAP decoders. A sub-iteration is defined as a processing cycle through a single MAP decoder within the set. Let i be one less than the number of sub-iterations, and consider q=1 with the apriori information at sub-iteration i equals the extrinsic information at sub-iteration i-1, *Lₐ*^{(*i*)}(*uₖ*) = *Le*^{(*i*-1)}(*uₖ*). Hence, the general (non-interleaved) iterative MAP decoding recursive extrinsic equation for the i-th sub-iteration is expressed in Equation 13 (described above).

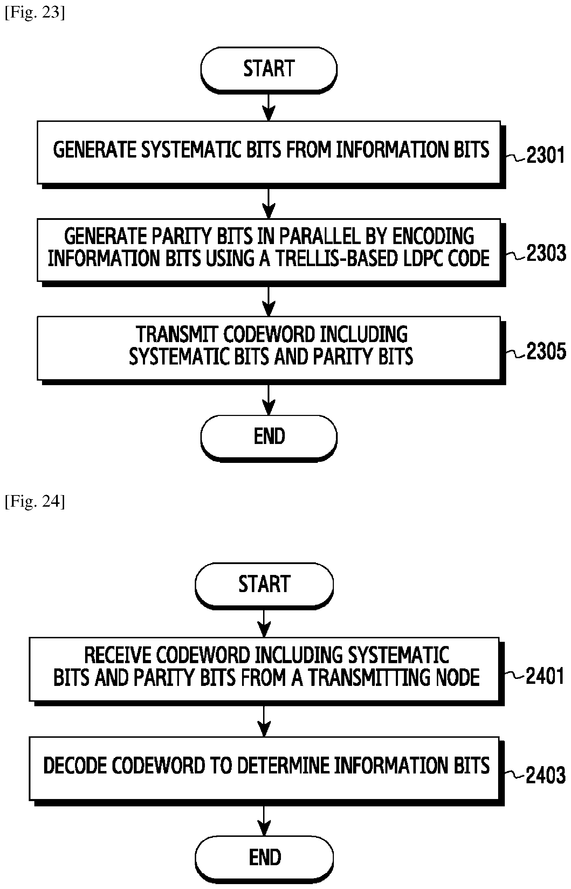

FIGURE 23 illustrates an operation process of a transmitting node according to this disclosure. While the flow chart depicts a series of sequential steps, unless explicitly stated, no inference should be drawn from that sequence regarding specific order of performance, performance of steps or portions thereof serially rather than concurrently or in an overlapping manner, or performance of the steps depicted exclusively without the occurrence of intervening or intermediate steps. The process depicted in the example depicted is implemented in the transmitting node such as, for example, in a base station or a terminal.

In block 2301, the transmitting node generates systematic bits from information bits. The systematic bits may be identical to the information bits.

In block 2303, the transmitting node generates parity bits in parallel by encoding the input bits using a trellis-based LDPC code. Herein, the trellis-based LDPC code is determined by transforming a LDPC base code into a code which enables trellis-based encodings. The LDPC base code is identified by a row weight, a column weight, and a lifting factor. The trellis-based LDPC code may be referred as a PC-LDPC convolutional code.

In block 2305, the transmitting node transmits a codeword including the systematic bits and the parity bits. Herein, the codeword includes a matrix including a systematic submatrix for the systematic bits and a parity check submatrix for the parity bits.

FIGURE 24 illustrates an operation process of a receiving node according to this disclosure according to this disclosure. While the flow chart depicts a series of sequential steps, unless explicitly stated, no inference should be drawn from that sequence regarding specific order of performance, performance of steps or portions thereof serially rather than concurrently or in an overlapping manner, or performance of the steps depicted exclusively without the occurrence of intervening or intermediate steps. The process depicted in the example depicted is implemented in the receiving node such as, for example, in a base station or a terminal.

In block 2401, the receiving node receives a codeword including systematic bits and parity bits from a transmitting node. Herein, the parity bits generated, at the transmitting node, in parallel by encoding the input bits using a trellis-based LDPC code. The trellis-based LDPC code is determined by transforming a LDPC base code into a code which enables trellis-based encodings. The LDPC base code is identified by a row weight, a column weight, and a lifting factor. The trellis-based LDPC code may be referred as a PC-LDPC convolutional code.

In block 2403, the receiving node decodes the codeword to determine information bits. Specifiacally, the receiving node determines a PC-LDPC convolutional code in a form of a matrix including a systematic submatrix for the systematic bits and a parity check submatrix for the parity bits. Then, the receiving node decodes the PC-LDPC convolutional code into the systematic bits, for each row of the PC-LDPC convolutional code, determines, from the PC-LDPC convolutional code, a specific quasi-cyclical domain of a set of rows that is different from any other quasi-cyclical domain of another set of rows of the PC-LDPC convolutional code, and performs MAP decoding processes on the shifted bits of the set of rows in parallel.

Although the present disclosure has been described with an exemplary embodiment, various changes and modifications may be suggested to one skilled in the art. It is intended that the present disclosure encompass such changes and modifications as fall within the scope of the appended claims.

## Claims

1. A method for encoding data at a transmitting node (102) in a wireless communication system using a parallel concatenation of a trellis-based, quasi-cyclic, low density parity check code, TQC-LDPC, convolutional code, the TQC-LDPC convolutional code being based on an underlying regular, quasi-cyclic, spatially coupled low density parity check, SC-LDPC, code matrix *H* with a row weight *Wᵣ*, a column weight *W_{c}*, and a lifting factor Z, the method comprising:
receiving an input sequence (505) including systematic data in the form of a group of Z systematic bits, denoted Z-group systematic bit set *x_{z}(n)*, where n is an index of the input sequence;
generating a systematic portion matrix *H_{sys}* with *J*=*W_{c}* rows, each denoted as Z-row, by transforming the regular, quasi-cyclic, SC-LDPC code matrix H into a streaming parity check code matrix with J Z-rows and separating the systematic portion of said streaming parity check matrix;
generating, for each *j*, a cyclically shifted Z-group systematic bit set *x_{z}^{(j)}(n)* from the Z-group systematic bit set *x_{z}(n)* using the corresponding quasi-cyclic shift value from the j-th Z-row of the systematic portion matrix *H_{zsys}*, where *j*=*0,* ... *,J-1*;
encoding each cyclically shifted Z-group systematic bit set *x_{z}^{(j)}(n)* with a corresponding *j-th* recursive systematic convolutional, RSC, encoder set (506a, 506b, 506c) consisting of Z identical single bit RSC encoders (508₀, 508₁,... 508_{z-1}) to obtain a *j-th* Z-group parity bit set *y_{z(j)}(n), j*=*0,* ... *,J-1*; and
outputting and transmitting the Z-group systematic bit set *x_{z}(n)* (515) or one of the cyclically shift Z-group systematic bit sets *x_{z}^{(j)}(n)* (510a, 510b, 510c), and the Z-group parity bit sets *y_{z}^{(j)}(n), j*=*0, ,J-1* (520, 525, 530) to a receiver node (116).

2. The method of claim 1, wherein the code rate is less than one-half.

3. The method of claim 1, wherein a rate of the TQC-LDPC convolutional code is increased by a puncturing operation.

4. The method of claim 1, further comprising:
modifying quasi-cyclic values of the TQC-LDPC convolutional code.

5. The method of claim 1, further comprising:
shifting each other row in the TQC-LDPC convolutional code relative to a reference row in which all shift entries denote a unity matrix.

6. A method for decoding parallel concatenated, trellis-based, quasi-cyclic low density parity check code, TQC-LDPC, convolutional encoded data at a receiving node (116) in a wireless communication system, the method comprising:
receiving a log-likelihood ratio, LLR, sequence (610) including systematic LLRs in the form of a group of Z LLR values, denoted *Rx_{z}(n)* (615), corresponding to Z systematic bits denoted Z-group systematic bit set *x_{z}(n)*, and including J sets of Z-group parity LLRs, denoted *Ry_{z}^{(j)}(n)* corresponding to J Z-group parity bit sets *y_{z}^{(j)}(n), J*=*0, ...* ,*J-*1, where n is an index of the LLR sequence;
wherein the received LLR sequence is encoded at a transmitting node (102), based on an underlying regular , quasi-cyclic, spatially coupled low density parity check, SC-LDPC, code matrix *H* with a row weight *Wᵣ*, a column weight *W_{c}*, and a lifting factor Z, by
generating a systematic portion matrix *H_{sys}* with *J*=*W_{c}* rows, each denoted as Z-row, by transforming the regular, quasi-cyclic, SC-LDPC code matrix *H* into a streaming parity check code matrix with *J* Z-rows and separating the systematic portion of said streaming parity check matrix;
generating, for each *j*, a cyclically shifted Z-group systematic bit set *x_{z}^{(j)}(n)* from the Z-group systematic bit set *x_{z}(n)* using the corresponding quasi-cyclic shift value from the *j*-th Z-row of the systematic portion matrix *H_{zsys}*, where *j*=*0,* ... *,J-1*; and
encoding each cyclically shifted Z-group systematic bit set *x_{z}^{(j)}(n)* with a corresponding *j-th* recursive systematic convolutional, RSC, encoder set (506a, 506b, 506c) consisting of Z identical single bit RSC encoders (508₀, 508₁,... 508_{z-1}) to obtain the *j-th* Z-group parity bit set *y_{z}^{(j)}(n), j*=*0, ... ,J-1*; and
iteratively decoding the received LLR sequence using a plurality of *J* Z-grouped maximum a-posteriori, Z-MAP, decoder sets (606a, 606b, 606c) exchanging extrinsic information after each sub-iteration, the iterative decoding comprising the steps of
receiving a different Z-group parity LLR set, *Ry_{z}^{(j)}(n)*, (620, 625, 630) and a Z-group a-priori LLRs *La_{z}^{(j)}(n)* corresponding to *x_{z}^{(j)}(n)* at each *j-th* Z-MAP decoder set consisting of Z parallel and independent MAP decoders (608₀, 608₁,... ,608_{z-1}), *j*=*0,* ...,*J-1,*
receiving additionally the Z-group systematic LLR set *Rx_{z}(n)* at at least one of the *J* Z-MAP decoder sets, and
at each *j-th* Z-MAP decoder set, *j*=*0,* ...,*J*-*1*, processing during a sub-iteration the corresponding Z-group LLR input set at a different interleaved domain determined by the corresponding *H_{sys}* Z-row and outputting a decoded version of *x_{z}^{(j)}(n)* and a set of Z extrinsic LLR values *Le_{z}^{(j)}(n) corresponding* to a-priori LLRs *La_{z}^{(j)}(n)* to be selectively used as a-priori LLRs in the next sub-iteration at a different Z-MAP decoder set.

7. An apparatus comprising means to implement the method of one of claims 1 to 6.

## Patentansprüche

1. Verfahren zum Codieren von Daten an einem Sendeknoten (102) in einem drahtlosen Kommunikationssystem unter Verwendung einer parallelen Verkettung eines Trellis-basierten, quasi-zyklischen, Low-Density-Parity-Check-Code-, TQC-LDPC-, Faltungscodes, wobei der TQC-LDPC-Faltungscode auf einer zugrundeliegenden regulären, quasi-zyklischen, räumlich gekoppelten Low-Density-Parity-Check-, SC-LDPC, Codematrix *H* mit einem Zeilengewicht *Wᵣ*, einem Spaltengewicht *W_{c}* und einem Hebefaktor Z basiert, das Verfahren umfassend:
Empfangen einer Eingangssequenz (505), die systematische Daten in Form einer Gruppe von Z systematischen Bits enthält, bezeichnet als systematischer Bit-Satz der Z-Gruppe *x_{z}(n)*, wobei *n* ein Index der Eingangssequenz ist;
Erzeugen einer systematischen Teilmatrix *H_{sys}* mit *J*=*W_{c}* Zeilen, jeweils bezeichnet als Z-Zeile, durch Umwandeln der regulären, quasi-zyklischen SC-LDPC-Codematrix *H* in eine Streaming-Paritätsprüf-Codematrix mit *J* Z-Zeilen und Trennen des systematischen Teils der Streaming-Paritätsprüfmatrix;
Erzeugen, für jedes *j*, eines zyklisch verschobenen systematischen Z-Gruppen-Bitsatzes *x_{z}^{(j)}(n)* aus dem systematischen Z-Gruppen-Bitsatz *x_{z}(n)* unter Verwendung des entsprechenden quasi-zyklischen Verschiebungswerts aus der *j*-ten Z-Zeile der systematischen Teilmatrix *H_{zsys}*, wobei *j*=*0,... ,J-1;*
Codieren jedes zyklisch verschobenen systematischen Z-Gruppen-Bitsatzes mit einem *x_{z}^{(j)}(n*) entsprechendenj-ten rekursiven systematischen Faltungs-, RSC-, Codierersatz (506a, 506b, 506c) bestehend aus Z identischen Einzelbit-RSC-Codierern (508₀, 508₁,...508_{z-1}), um einen j-ten Z-Gruppen-Paritätsbitsatz *y_{z}^{(j)}(n)*, *j*=*0,...,J-1* zu erlangen; und
Ausgeben und Senden des systematischen Z-Gruppen-Bitsatzes *x_{z}(n*) (515) oder einer der zyklisch verschobenen systematischen Z-Gruppen-Bitsätze *x_{z}^{(j)}(n*) (510a, 510b, 510c) und der Z-Gruppen-Paritätsbitsätze *y_{z}*^{(*j*)}*(n*) *j*=*0,... ,J-1* (520, 525, 530) an einen Empfängerknoten (116).

2. Verfahren nach Anspruch 1, wobei die Coderate weniger als die Hälfte ist.

3. Verfahren nach Anspruch 1, wobei eine Rate des TQC-LDPC-Faltungscodes durch eine Punktierungsoperation erhöht wird.

4. Verfahren nach Anspruch 1, ferner umfassend:
Modifizieren der quasi-zyklischen Werte des TQC-LDPC-Faltungscodes.

5. Verfahren nach Anspruch 1, ferner umfassend:
Verschieben jeder anderen Zeile in dem TQC-LDPC-Faltungscode in Bezug auf eine Referenzzeile, in der alle Verschiebungseinträge eine Einheitsmatrix bezeichnen.

6. Verfahren zum Dekodieren parallel verketteter, Trellis-basierter, quasi-zyklischer Low-Density-Parity-Check-Code, TQC-LDPC, faltungskodierter Daten an einem Empfangsknoten (116) in einem drahtlosen Kommunikationssystem, das Verfahren umfassend:
Empfangen einer Log-Likelihood-Ratio, LLR, Sequenz (610) die systematische LLRs in Form einer Gruppe von Z LLR-Werten enthält, bezeichnet als *Rx_{z}(n)* (615), entsprechend Z systematischen Bits, bezeichnet als systematischer Z-Gruppen-Bitsatz *x_{z}(n)*, und einschließlich *J* Sätzen von Z-Gruppen-Paritäts-LLRs, bezeichnet als *Ry*_{z}^{(*j*)}*(n*), entsprechend JZ-Gruppen-ParitätsBitsätze *y_{z}*^{(*j*)}*(n*), *j*=*0,... ,J-1*, wobei *n* ein Index der LLR-Sequenz ist;
wobei die empfangene LLR-Sequenz an einem Sendeknoten (102) basierend auf einer zugrundeliegenden regulären, quasi-zyklischen, räumlich gekoppelten Low-Density-Parity-Check-, SC-LDPC-, Codematrix *H* mit einem Zeilengewicht *Wᵣ,* einem Spaltengewicht *W_{c}* und einem Hebungsfaktor Z codiert wird, durch
Erzeugen einer systematischen Teilmatrix *H_{sys}* mit *J*=*W_{c}* Zeilen, jeweils bezeichnet als Z-Zeile, durch Umwandeln der regulären, quasi-zyklischen SC-LDPC-Codematrix *H* in eine Streaming-Paritätsprüf-Codematrix mit *J* Z-Zeilen und Trennen des systematischen Teils der Streaming-Paritätsprüfmatrix;
Erzeugen, für jedes *j*, eines zyklisch verschobenen systematischen Z-Gruppen-Bitsatzes *x_{z}^{(j)}(n*) aus dem systematischen Z-Gruppen-Bitsatz *x_{z}(n*) unter Verwendung des entsprechenden quasi-zyklischen Verschiebungswerts aus der *j*-ten Z-Zeile der systematischen Teilmatrix *H_{zsys}*, wobei *j*=*0,... ,J-1;*
und
Codieren jedes zyklisch verschobenen systematischen Z-Gruppen-Bitsatzes *x_{z}^{(j)}(n*) mit einer entsprechenden *j-ten* rekursiven systematischen Faltungs-, RSC-, Codierersatz (506a, 506b, 506c) bestehend aus Z identischen Einzelbit-RSC-Codierern (508₀, 508₁,... 508_{z-1}), um den *j-ten* Z-Gruppen-Paritätsbitsatz *y_{z}*^{(*j*)}*(n*) *,j*=*0,... ,J-1* zu erlangen;
und
iteratives Dekodieren der empfangenen LLR-Sequenz unter Verwendung einer Vielzahl von *J* Z-gruppierten maximalen a-posteriori, Z-MAP, Decodersätzen (606a, 606b, 606c), die nach jeder Subiteration extrinsische Informationen austauschen, das iterative Decodieren umfassend die folgenden Schritte
empfangen eines anderen Z-Gruppen-Paritäts-LLR-Satzes, *Ry_{z}*^{(*j*)}*(n*) (*n*), (620, 625, 630)
und eines Z-Gruppen-a-priori-LLRs *La_{z}*^{(*j*)}*(n*) entsprechend *x_{z}^{(j)}(n*)
an jedem *j-ten* Z-MAP-Decodersatz, bestehend aus Z parallelen und unabhängigen MAP-Decodern (608₀, 608₁,...,608_{z-1}),
*j*=*0,...,J-1,*
zusätzliches Empfangen des systematischen Z-Gruppen-LLR-Satzes *Rx_{z}(n)* an an mindestens einem der *J* Z-MAP-Decodersätze, und
bei jedem *j-ten* Z-MAP-Decodersatz, *j*=*0,...,J-1,* Verarbeiten, während einer Subiteration, des entsprechenden Z-Gruppen-LLR-Eingabesatzes in einer anderen verschachtelten Domäne, bestimmt durch die entsprechende *H_{sys}-*Z*-*Zeile, und Ausgeben einer decodierten Version von *x_{z}*^{(*j*)}*(n*)
und eines Satzes von Z extrinsischen LLR-Werten *Le_{z}*^{(*j*)}*(n*)
die a-priori-LLRs *La_{z}*^{(*j*)}*(n*) entsprechen, um selektiv als a-priori-LLRs in der nächsten Subiteration in einem anderen Z-MAP-Decodersatz verwendet zu werden.

7. Vorrichtung, umfassend Einrichtungen, die zum Implementieren des Verfahrens nach einem der Ansprüche 1 bis 6 konfiguriert sind.

## Revendications

1. Procédé permettant le codage de données au niveau d'un noeud de transmission (102) dans un système de communication sans fil à l'aide d'une concaténation parallèle d'un code convolutionnel de code de contrôle de parité à faible densité, quasi-cyclique, en treillis, TQC-LDPC, le code convolutionnel TQC-LDPC étant basé sur une matrice *H* fondamentale de code de contrôle de parité à faible densité à couplage spatial, SC-LDPC, quasi-cyclique, régulière avec un poids de rangée *Wᵣ*, un poids de colonne *W_{c}* et un facteur d'élévation Z, le procédé comprenant :
la réception d'une séquence d'entrée (505) comprenant des données systématiques sous la forme d'un groupe de *Z* bits systématiques, désigné ensemble de bits systématiques du groupe Z *x_{z}(n)*, où *n* est un indice de la séquence d'entrée ;
la génération d'une matrice de partie systématique *H_{sys}* avec *J* = *W_{c}* rangées, chacune désignée en tant que rangée Z, en transformant la matrice *H* de code SC-LDPC régulier, quasi-cyclique en une matrice de code de contrôle de parité en continu avec *J* rangées Z et en séparant la partie systématique de ladite matrice de contrôle de parité en continu ;
la génération, pour chaque *j*, d'un ensemble de bits systématiques du groupe Z décalé cycliquement *x_{z}^{(j)}(n)* à partir de
l'ensemble de bits systématiques du groupe Z *x_{z}(n)* à l'aide de la valeur de décalage quasi-cyclique correspondante à partir de la *j*-ième rangée Z de la matrice de partie systématique *H_{zsys}*, où *j* = *0,...*
*,J-1* ;
le codage de chaque ensemble de bits systématiques du groupe Z décalé cycliquement *x_{z}^{(j)}(n)* avec un *j-ième* ensemble de codeurs convolutionnel systématique récursif, RSC, correspondant (506a, 506b, 506c) constitué de Z codeurs RSC de bit unique identiques (508₀, 508₁,... 508_{z-1}) pour obtenir un *j-ième* ensemble de bits de parité du groupe Z *y_{z}^{(j)}(n) j* = *0,...,J-1* et
l'émission en sortie et la transmission de l'ensemble de bits systématiques du groupe Z *x_{z}(n)* (515) ou l'un de l'ensemble de bits systématiques du groupe Z à décalage cyclique *x_{z}^{(j)}(n)* (510a, 510b, 510c), et de l'ensemble de bits de parité du groupe Z *y_{z}^{(j)}(n) j* = *0, .... J- 1* (520, 525, 530) à un noeud récepteur (116).

2. Procédé selon la revendication 1, ledit taux de code étant inférieur à la moitié.

3. Procédé selon la revendication 1, un taux du code convolutionnel TQC-LDPC étant augmenté par une opération de perforation.

4. Procédé selon la revendication 1, comprenant en outre :
la modification des valeurs quasi-cycliques du code convolutionnel TQC-LDPC.

5. Procédé selon la revendication 1, comprenant en outre :
le décalage de l'une de l'autre rangée dans le code convolutionnel TQC-LDPC par rapport à une rangée de référence dans laquelle toutes les entrées de décalage désignent une matrice unité.

6. Procédé permettant de décoder des données codées convolutionnelles de code de contrôle de parité à faible densité, quasi-cyclique, en treillis, TQC-LDPC, concaténé parallèlement au niveau d'un noeud de réception (116) dans un système de communication sans fil, le procédé comprenant :
la réception d'une séquence de rapport de vraisemblance logarithmique, LLR, (610) comprenant des LLR systématiques sous la forme d'un groupe de Z valeurs LLR, désignées *Rx_{z}(n)* (615), correspondant aux Z bits systématiques désignés ensemble de bits systématiques du groupe Z *x_{z}(n)*, et comprenant *J* ensembles de LLR de parité du groupe Z, désignés *Ry_{z}^{(j)}(n)* correspondant à *J* ensembles de bits de parité de groupe Z *y_{z}^{(j)}(n)*, *j* = *0,...,J-1*,
où *n* est un indice de la séquence LLR ;
ladite séquence LLR reçue étant codée au niveau d'un noeud de transmission (102), sur la base d'une matrice *H* fondamentale de code de contrôle de parité à faible densité à couplage spatial, SC-LDPC, régulier, quasi-cyclique avec un poids de rangée *Wᵣ*, un poids de colonne *W_{c}*, et un facteur d'élévation Z, par
la génération d'une matrice de partie systématique *H_{sys}* avec *J* = *W_{c}* rangées, chacune désignée en tant que rangée Z, en transformant la matrice H de code SC-LDPC régulier, quasi-cyclique, en une matrice de code de contrôle de parité en continu avec *J* rangées Z et en séparant la partie systématique de ladite matrice de contrôle de parité en continu ;
la génération, pour chaque *j*, d'un ensemble de bits systématiques du groupe Z décalé cycliquement *x_{z}^{(j)}(n)* à partir de l'ensemble de bits systématiques du groupe Z *x_{z}(n)* à l'aide de la valeur de décalage quasi-cyclique correspondante à partir de la *j*-ième rangée Z de la matrice de partie systématique *H_{zsys}*, où *j* = *0,... ,J-1* ; et
le codage de chaque ensemble de bits systématiques du groupe Z décalé cycliquement *x_{z}^{(j)}(n)* avec un *j-ième* ensemble de codeurs convolutionnel systématique récursif, RSC, correspondant (506a, 506b, 506c) constitué de Z codeurs RSC de bit unique identiques (508₀, 508₁,... 508_{z-1}) pour obtenir le *j-ième* ensemble de bits de parité du groupe Z *y_{z}^{(j)}(n), j* = *0,...,J-1* et
le décodage itératif de la séquence LLR reçue à l'aide d'une pluralité de *J* ensembles de décodeurs maximum a posteriori du groupe Z, Z-MAP, (606a, 606b, 606c) échangeant des informations extrinsèques après chaque sous-itération, le décodage itératif comprenant les étapes de réception d'un ensemble LLR de parité du groupe Z différent, *Ry_{z}^{(j)}(n) (n)* (620, 625, 630) et un LLR a priori du groupe Z *La_{z}^{(j)}(n)* correspondant à *x_{z}^{(j)}(n)* au niveau de chaque *J-ième* ensemble de décodeurs Z-MAP constitué de Z décodeurs MAP parallèles et indépendants (608₀, 608₁,..., 608_{z-1}),
*j*=*0,...,J-1*, la réception en plus de l'ensemble LLR systématique de groupe Z *Rx_{z}(n)* au niveau d'au moins l'un des *J* ensembles de décodeurs Z-MAP, et
au niveau de chaque *j-ième* ensemble de décodeurs Z-MAP, *j* = *0,...,J-1*, le traitement durant une sous-itération de l'ensemble d'entrées LLR du groupe Z correspondant au niveau d'un domaine entrelacé différent déterminé par la rangée Z de *H_{sys}* correspondante et l'émission en sortie d'une version décodée de *x_{z}^{(j)}(n)* et d'un ensemble de Z valeurs LLR extrinsèques *Le_{z}^{(j)}(n)* correspondant aux LLR a priori *La_{z}^{(j)}(n)* à utiliser sélectivement en tant que LLR a priori dans la prochaine sous-itération au niveau d'un ensemble de décodeurs Z-MAP différent.

7. Appareil comprenant un moyen configuré pour mettre en oeuvre le procédé de l'une des revendications 1 à 6.
